(19) **Europäisches Patentamt European Patent Office Office européen des brevets**

(11) **EP 4 334 731 B1**

(12) **EUROPEAN PATENT SPECIFICATION**

(45) Date of publication and mention
of the grant of the patent:
**07.05.2025 Bulletin 2025/19**

(21) Application number: **22754403.8**

(22) Date of filing: **23.07.2022**

(51) International Patent Classification (IPC):
***G01R 31/387*** (2019.01)

(52) Cooperative Patent Classification (CPC):
**G01R 31/387;** G01R 31/367

(86) International application number:
**PCT/EP2022/070718**

(87) International publication number:
**WO 2024/022569 (01.02.2024 Gazette 2024/05)**

(54) **METHOD FOR EXPERIMENTAL DETERMINATION OF BATTERY PARAMETERS AND THEIR USE**

VERFAHREN ZUR VERSUCHSMÄSSIGEN BESTIMMUNG VON BATTERIEPARAMETERN UND DEREN VERWENDUNG

PROCÉDÉ DE DÉTERMINATION EXPÉRIMENTALE DE PARAMÈTRES DE BATTERIE ET DE LEUR UTILISATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**13.03.2024 Bulletin 2024/11**

(73) Proprietor: **SVEUCILISTE U ZAGREBU FAKULTET ELEKTROTEHNIKE I RACUNARSTVA**
**10000 Zagreb (HR)**

(72) Inventors:
• **PANDZIC, Hrvoje**
**10000 Zagreb (HR)**
• **BOBANAC, Vedran**
**10000 Zagreb (HR)**
• **BASIC, Hrvoje**
**10000 Zagreb (HR)**

(74) Representative: **Bihar, Zeljko**
**Admoveo d.o.o.**
**Gracanska cesta 111**
**10000 Zagreb (HR)**

(56) References cited:
CN-A- 111 273 177    CN-A- 113 125 967

• **BOBANAC VEDRAN ET AL: "Determining Lithium-ion Battery One-way Energy Efficiencies: Influence of C-rate and Coulombic Losses", IEEE EUROCON 2021 - 19TH INTERNATIONAL CONFERENCE ON SMART TECHNOLOGIES, IEEE, 6 July 2021 (2021-07-06), pages 385 - 389, XP033973130, DOI: 10.1109/ EUROCON52738.2021.9535542**
• **REDONDO-IGLESIAS EDUARDO ET AL: "Efficiency Degradation Model of Lithium-Ion Batteries for Electric Vehicles", IEEE TRANSACTIONS ON INDUSTRY APPLICATIONS, IEEE SERVICE CENTER, PISCATAWAY, NJ, US, vol. 55, no. 2, 31 March 2019 (2019-03-31), pages 1932 - 1940, XP011714330, ISSN: 0093-9994, [retrieved on 20190313], DOI: 10.1109/ TIA.2018.2877166**

**Description**

**Technical Field**

A present disclosure reveals a novel method for experimental determination of battery parameters and their use for SOE (State of Energy), SOC (State od Charge) and SOH (State of Health) calculations, for the given battery. The present disclosure also discusses the subsequent use of the mentioned values in everyday battery applications. Therefore, the technical field of the present disclosure can be regarded as arrangement for testing electrical properties, more particularly, for testing, measuring, or monitoring the electrical conditions of accumulators or electric batteries, with the use of hardware and software.

**Technical Problem**

Advances in the power electronics that convert DC power to AC have helped make battery storage systems increasingly reliable. Recent breakthroughs in advanced battery energy storage have shown the ability to deliver 5,000 to 10,000 charge/discharge cycles, or more. Advanced battery systems that trim daily peaks, requiring at least 365 cycles per year, could last more than 10 years and perhaps up to 30 years. In addition, there is a growing need for advanced batteries to store wind energy produced primarily during off-peak hours, and solar energy produced during shoulder hours, for subsequent on-peak consumption. These renewable applications will require 200 to 300 cycles per year. Also, when the renewables are not available, the battery could be used for arbitrage, buying low-cost energy at night and selling it during periods of high energy price, adding another 100 to 200 cycles per year. For all of the above said reasons, the determination of battery parameters is a must for a reliable usage once installed as a part of a power grid.

The main technical problem solved with the present disclosure is a method for experimental determination of battery one-way efficiencies for a given environmental temperature $T^E$, where the term "one-way efficiency" refers to charging or discharging battery efficiency only. The disclosed method is equally well applied to battery cycling protocol when subjected to the constant current (CC) or the constant power (CP) mode. It seems that such approach for the CC mode and the CP mode was never reported before in the technical field, in the form as hereby described.

The calculated one-way efficiencies in CC mode are subsequently used for determination of state-of-charge $SOC$ vector and calculated one-way efficiencies in CP mode are used for determination of state of energy $SOE$ vectors respectively. Furthermore, $SOC$ or $SOE$ vectors are used for determination of state-of-health $SOH$ for the given battery, through the change of the determined battery charge capacity $C^I$ or determined battery energy capacity $C^E$ in time.

**State of the Art**

For numerous reasons, even historical one, the $SOC$ vector or values are more used in the battery management than the $SOE$ vector. Perhaps, $SOE$ vector was first reported and defined in reference 1), in a coherent manner:

1) Mamadou, K., Lemaire, E., Delaille, A., Riu, D., Hing, S. E., & Bultel, Y. (2012). Definition of a State-of-Energy Indicator (SoE) for Electrochemical Storage Devices: Application for Energetic Availability Forecasting. Journal of the Electrochemical Society, 159(8), A1298-A1307. doi:10.1149/2.075208jes

References 2) and 3) use more or less the same technique for the $SOE$ vector determination:

2) PCT patent application published as WO2011/000872A1 for the invention METHOD FOR CALIBRATING AN ELECTROCHEMICAL BATTERY, invented by Mamadou, K. et al., subsequently granted as the European patent EP2449392B1 and the US patent US 9,075,117.

3) PCT patent application published as WO2013/175005A1 for the invention DEVICE AND METHOD FOR DETERMINING A POWER STATUS ACCORDING TO DATA FROM THE PROCESSING METHOD, invented by Fernandez E. et al., subsequently granted as the European patent EP2856187B1.

Reference 4) recognises the importance of one-way efficiency of charging and discharging, providing the battery system management based on the obtained $SOC$ vector associated with its time derivative via a non-linear model.
4) PCT patent application published as WO2018/084939A1 for the invention BATTERY SYSTEM MANAGEMENT THROUGH NON-LINEAR ESTIMATION OF BATTERY STATE OF CHARGE, invented by J.A. CRAWFORD et al., subsequently granted as several US patents.

Furthermore, reference 4) discusses the usage of the calculated model in balancing the power grid.

Below cited references 5) - 8) are found to be important for the present invention.

5) V. Bobanac, H. Bašić and H. Pandžić, "Determining Lithium-ion Battery One-way Energy Efficiencies: Influence of C-rate and Coulombic Losses," *IEEE EUROCON 2021 - 19th International Conference on Smart Technologies,* Lviv, Ukraine, 2021, pp. 385-389, doi: 10.1109/EUROCON52738.2021.9535542.

Reference 5) seems to be the closest prior art for the present invention. It addresses the lithium-ion battery efficiencies. In-house experiments were used to obtain: (i) charging/discharging curves with different C-rates and (ii) open-circuit voltage characteristic. The results were used to analyse battery coulombic and energy efficiencies, which lead to methodology for accurately assessing one-way energy efficiencies. Utilization of accurate one-way efficiencies potentially improves a variety of battery models and algorithms for state-of-charge estimation. In addition, residual capacities (after discharging with higher C-rates) are measured and their influence on roundtrip efficiencies is assessed. Reference 5) seems to be silent regarding the steps B and C regarding the method presented in this disclosure.

6) Chinese patent application CN111273177A for the invention METHOD OF ESTIMATING REMAINING AVAILABLE ENERGY OF BATTERY, filed in the name of Zhejiang Leapmotor Tech. Co. Ltd.

Reference 6) discloses a method for estimating the remaining available energy of the battery, and comprises establishing a three-dimensional curve map of SOC-temperature-SOE, establishing a sliding integration window and calculating the actual energy output value of the battery.

7) Chinese patent application CN113125967A for the invention LITHIUM BATTERY SOE CALCULATION METHOD BASED ON TEMPERATURE RISE PREDICTION, filed in the name of Ligao Shandong New Energy Tech Co. Ltd.

Reference 7) discloses a method for calculating state-of-charge of lithium battery based on temperature rise prediction, involves calculating state-of-charge according to battery discharge energy efficiency and residual discharge energy.

8) E. Redondo-Iglesias, P. Venet and S. Pelissier, "Efficiency Degradation Model of Lithium-Ion Batteries for Electric Vehicles," in IEEE Transactions on Industry Applications, vol. 55, no. 2, pp. 1932-1940, March-April 2019, doi: 10.1109/TIA.2018.2877166.

Reference 8) analyses efficiency degradation of lithium-ion batteries, reporting the high correlation between capacity fade and energy efficiency for the tested technologies. Two empirical models for energy efficiency degradation were developed in both technologies: the first one is based on the Eyring relationship and the second one lies on the existing correlation between capacity fade and efficiency.

## Summary of the Invention

The present disclosure reveals a novel method for experimental determination of battery parameters and their use. More particularly, the method for experimental determination of battery one-way efficiencies for a given environmental temperature $T^E$ is disclosed, where the said method comprises the following steps:

A. executing a battery cycling protocol where charging and discharging are performed with an external source/sink, and where the said protocol is selected from the constant current (CC) or the constant power (CP) mode;

- where at least two $C$ charging $C$-rates and at least two $D$ discharging $C$-rates are selected for the CC mode, or
- where at least two $C$ charging $P$-rates and at least two $D$ discharging $P$-rates are selected for the CP mode,

where the selected set of all $\Omega^C = \{c_1, c_2, ... , c_C\}$ and $\Omega^D = \{d_1, d_2, ... , d_D\}$ values forms $C \times D$ charge-discharge cycles for all possible $\{c, d\}$ pairs of values, and where the above cycling is repeated $J$ times resulting in total of $C \times D \times J$ charge-discharge cycles, with the provision that:

(i) each cycle is always started with depleted battery,
(ii) each charging in the CC mode or the CP mode is terminated as soon as the declared battery high voltage limit is reached,
(iii) each discharging in the CC mode or the CP mode is terminated as soon as the declared battery low voltage limit is reached,

B. determination of multiple roundtrip battery efficiencies $\eta_{c,d}^{cycle}$ for $C \times D$ different pairs of charging and discharging

$C$-rates or $P$-rates defined in step A, where for every performed cycle the said roundtrip efficiency per cycle $\eta_{c,d,j}^{cycle}$, for selected $c$, $d$ and is calculated:

- in case of the selected CC mode, from the extracted charge $C_{c,d,j}^{dis}$ and the injected charge $C_{c,d,j}^{ch}$ into the said battery:

$$\eta_{c,d,j}^{cycle} = \frac{C_{c,d,j}^{dis}}{C_{c,d,j}^{ch}}$$

where the said charges $C_{c,d,j}^{ch}$ and $C_{c,d,j}^{dis}$ are obtained by numerical integration of the time-dependant charging current $I_{c,d,j}^{ch}(t)$ and the discharging current $I_{c,d,j}^{dis}(t)$ :

$$C_{c,d,j}^{ch} = \int I_{c,d,j}^{ch}(t) \cdot dt$$

$$C_{c,d,j}^{dis} = \int I_{c,d,j}^{dis}(t) \cdot dt$$

where the said currents $I_{c,d,j}^{ch}(t)$ and $I_{c,d,j}^{dis}(t)$ are logged during every cycle, or

- in case of the selected CP mode, from the extracted energy $E_{c,d,j}^{dis}$ and the injected energy $E_{c,d,j}^{ch}$ into the said battery:

$$\eta_{c,d,j}^{cycle} = \frac{E_{c,d,j}^{dis}}{E_{c,d,j}^{ch}}$$

where the said energies $E_{c,d,j}^{ch}$ and $E_{c,d,j}^{dis}$ are obtained by numerical integration of the time-dependant charging power $P_{c,d,j}^{ch}(t)$ and the discharging power $P_{c,d,j}^{dis}(t)$ :

$$E_{c,d,j}^{ch} = \int P_{c,d,j}^{ch}(t) \cdot dt$$

$$E_{c,d,j}^{dis} = \int P_{c,d,j}^{dis}(t) \cdot dt$$

where the said powers $P_{c,d,j}^{ch}(t)$ and $P_{c,d,j}^{dis}(t)$ are logged during every cycle, and

where the obtained roundtrip efficiencies per cycle $\eta_{c,d,j}^{cycle}$ are averaged by the number of repetitions *J* from step A, yielding the roundtrip battery efficiencies $\eta_{c,d}^{cycle}$ for selected *C* and *D* values to read:

$$\eta_{c,d}^{cycle} = \frac{\sum_{j=1}^{J} \eta_{c,d,j}^{cycle}}{J}$$

C. determination of one-way efficiencies from the calculated roundtrip battery efficiencies $\eta_{c,d}^{cycle}$ in step B, where

$\eta_c^{ch}$ and $\eta_d^{dis}$ denote one-way charging and discharging efficiencies, respectively, by solving the nonlinear optimisation problem which contains $C + D$ unknowns and $C \times D$ equations:

$$Minimize \sum_{c \in \Omega^C} \sum_{d \in \Omega^D} s_{c,d}^2$$

subjected to the following constrains:

$$\eta_c^{ch} \cdot \eta_d^{dis} = \eta_{c,d}^{cycle} + s_{c,d} \qquad \forall c \in \Omega^C, d \in \Omega^D$$

$$0 \le \eta_c^{ch} \le 1, \forall\, c \in \Omega^C$$

$$0 \le \eta_d^{dis} \le 1, \forall\, d \in \Omega^D$$

wherein $s_{c,d}$ is a slack variable, and where the solution of the above said optimisation problem gives $\eta_c^{ch}$ and $\eta_d^{dis}$ multiplication of which diverges from the measured efficiency $\eta_{c,d}^{cycle}$ the least for every selected $\{c, d\}$ pair of values.

From the above, it is rather straightforward to calculate one-way efficiency characteristics for the CC mode and the CP mode, as shown in the detailed description.

In the first embodiment, the cited method for modelling battery one-way efficiency characteristics in the CC mode is used for determination of the state-of-charge $SOC$ vector. In one variant, the cited method is used for experimental determination of battery charge capacity $C^I$. In yet another variant, said one-way efficiency characteristics are used for determination of the state-of-health $SOH$ parameter expressed in percentage 0-100%, via the change of battery charge capacity $C^I$ in time.

In the second embodiment, the cited method for modelling battery one-way efficiency characteristics in the CP mode is used for determination of the state-of-energy $SOE$ vector. In one variant, the cited method is used for experimental determination of battery energy capacity $C^E$. In yet another variant, said one-way efficiency characteristics are used for determination of the state-of-health $SOH$ parameter expressed in percentage 0-100%, via the change of battery energy capacity $C^E$ in time.

## Description of Figures

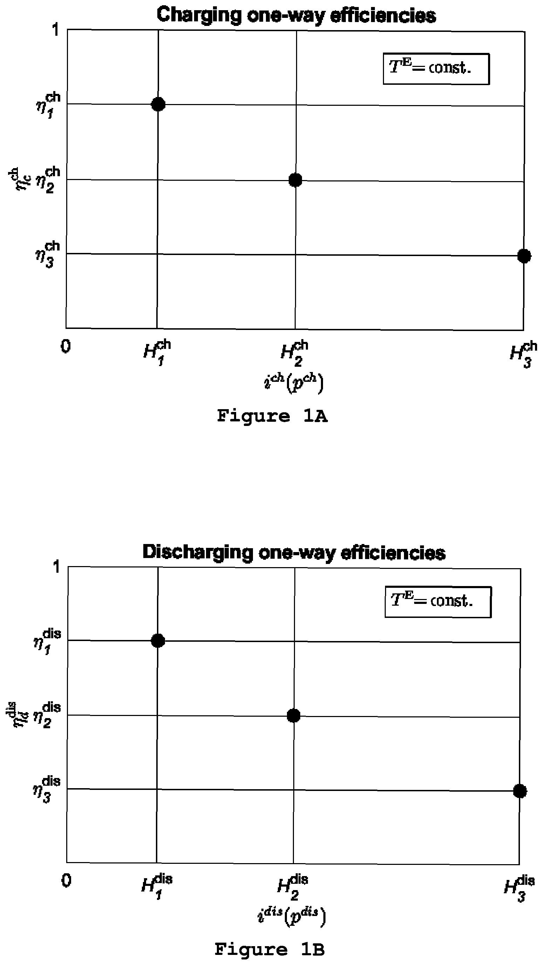

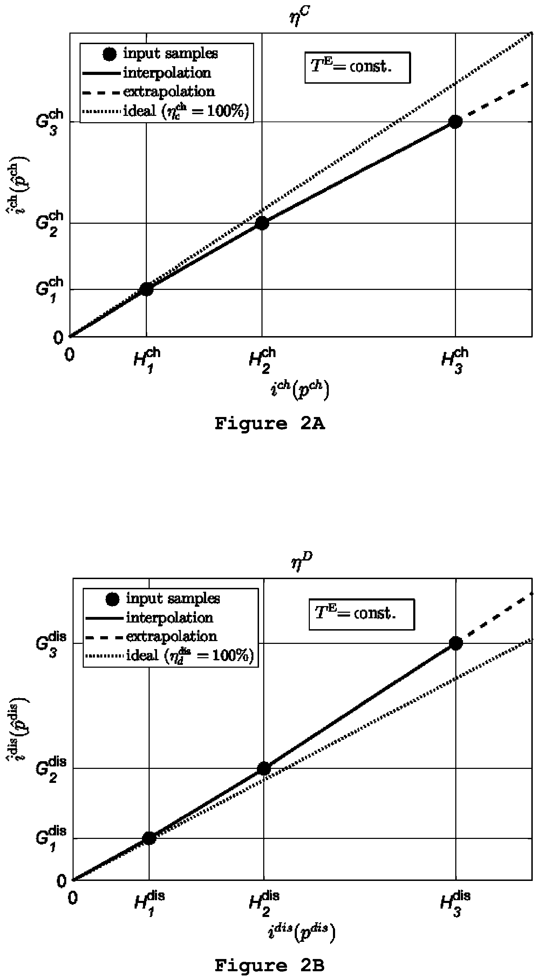

The disclosed method is depicted in Figures 1A, 1B, 2A and 2B.

Figure 1A shows charging one-way efficiencies $\eta_c^{ch}$, measured and calculated in three points ($C = 3$), for the given environmental temperature $T^E$ vs. gross current (power) taken from an external source $i^{ch}$ ($p^{ch}$), corresponding to the selected charging C-rate (P-rate), denoted as a set of $H_c^{ch}$ values in Figure 2A.

Figure 1B shows discharging one-way efficiencies $\eta_d^{dis}$, measured and calculated in three points ($D = 3$), for the given environmental temperature $T^E$ vs. net current (power) delivered to an external sink $i^{dis}$ ($p^{dis}$), corresponding to the selected discharging C-rate (P-rate), denoted as a set of $H_d^{dis}$ values in Figure 2B.

Figure 2A represents a piecewise linear efficiency charging characteristic $\eta^C$, obtained via interpolation and extrapolation from input measured data and recalculated according to the proposed model. The $\eta^C$ function connects $G_c^{ch}$ and $H_c^{ch}$ values, where $G_c^{ch}$ values denote $\hat{i}^{ch}$ ($\hat{p}^{ch}$) which represents the net current (power) injected in the battery during charging, to read $G_c^{ch} = \eta_c^{ch} \cdot H_c^{ch}$.

Similarly, Figure 2B represents a piecewise linear efficiency discharging characteristic $\eta^D$, obtained via interpolation or extrapolation from input measured data and recalculated according to the proposed model. The $\eta^D$ function

connects $G_d^{dis}$ and $H_d^{dis}$ values, where $G_d^{dis}$ values denote $\tilde{\imath}^{dis}$ ($\hat{\rho}^{dis}$) which represents a gross current (power) extracted from the battery during discharging, to read $G_d^{dis} = H_d^{dis}/\eta_d^{dis}$ .

### Detailed Description

A present disclosure, as mentioned before, reveals a novel method for experimental determination of battery parameters and their use for SOE (State of Energy), SOC (State od Charge) and SOH (State of Health) calculations for the given battery.

It is well-known in the art that the battery characteristics strongly depend on environmental temperature $T^E$. So, the present disclosure reveals the method executed at given environmental temperature $T^E$ which can be straightforwardly broaden to a temperature-dependent model by a person skilled in the art. The experimental determination of battery parameters consists of the steps described below.

### Step A

In step A, it is necessary to execute a battery cycling protocol by performing experimental measurements. Battery cycling protocol is a protocol where charging and discharging are performed with an external source/sink. In the field, it is common to select either the constant current (CC) cycling mode or the constant power (CP) cycling mode. To perform the experimentation, the following equipment were used:

(i) Professional bi-directional DC power supply Itech IT-M3413, coupled with a proprietary NI LabVIEW software for control and supervision of battery experiments. Characteristics of the bi-directional DC power supply are as follows:

- Output DC Voltage: from 0 to 150 V

  - Setup Resolution: 1 mV
  - Accuracy: < 0.1 · $U_{max}$

- Output DC Current: from -12 A to 12 A

  - Setup Resolution: 1 mA
  - Accuracy: < 0.1 · $I_{max}$ + 0.1% · $I_{current}$

- Output Power: from -200 W to 200 W

  - Setup Resolution: 0.1 W
  - Accuracy: < 0.1 · $P_{max}$

(ii) Commercial battery cells:

- NMC (lithium-nickel-manganese-cobalt-oxide) 18650

  - Declared nominal capacity: 3000 mAh
  - Declared nominal voltage: 3.6V

- LFP (lithium-iron-phosphate) 18650

  - Declared nominal capacity: 1500 mAh
  - Declared nominal voltage: 3.2V

- LCO (lithium-cobalt-oxide) 18650

  - Declared nominal capacity: 3200 mAh
  - Declared nominal voltage: 3.75V

- LTO (lithium-titanate) 18650

- Declared nominal capacity: 1300 mAh
- Declared nominal voltage: 2.75V.

The afore said equipment were used in the manner that is obvious for a person skilled in the art.

For the proper execution, at least two $C$ charging $C$-rates and at least two $D$ discharging $C$-rates are selected for the CC mode. Each selected $C$-rate denotes the measure of the rate at which a battery charges or discharges under constant current relative to its declared charge capacity, usually expressed in Ampere hours, i.e., Ah units. Similarly, at least two $C$ charging $P$-rates and at least two $D$ discharging $P$-rates are selected for the CP mode. Hereby, each selected $P$-rate denotes the measure of the rate at which a battery charges or discharges under constant power relative to its declared energy capacity, usually expressed in Watt hours, i.e., Wh units.

The selected set of all $\Omega^C = \{c_1, c_2, ..., c_C\}$ and $\Omega^D = \{d_1, d_2, ..., d_D\}$ values forms $C \times D$ charge-discharge cycles for all possible $\{c, d\}$ pairs of values. For increasing the model's accuracy, the above cycling is repeated $J$ times resulting in total of $C \times D \times J$ charge-discharge cycles. It is desirable for $J$ to be greater than 1 for improving accuracy, but the model can be run even for $J = 1$. Each cycle should fulfil the following conditions (i)-(iii) set below:

(i) each cycle is always started with a depleted battery, where depleted means that a non-depleted battery is discharged until the battery's low voltage limit has been reached with the provision that the discharging battery C-rate or P-rate is equal to the cycle's discharging C-rate or P-rate in step (iii), which will ensure the same starting and finishing point of the cycle in terms of currents and voltages,

(ii) each charging in the CC mode or the CP mode is terminated as soon as the declared battery high voltage limit is reached, and

(iii) each discharging in CC mode or CP mode is terminated as soon as the declared battery low voltage limit is reached.

The mentioned battery low/high voltage limits are usually declared by the manufacturer or by the used battery management system which protects the battery from an irreversible damage.

Possibly simpler and less time consuming, but also less accurate variation of the above conditions (i)-(iii) is to relax the cycle's starting point stated in (i), so that the battery is discharged to its low voltage limit with any C-rate or P-rate. This means that the starting and finishing point of the cycle (ii)-(iii) will not be exactly the same in terms of measured currents and voltages, however depending on the desired application, subsequent results may still be sufficiently accurate.

The above stated cycling conditions (i)-(iii) are intended for charging/discharging between the battery voltage limits, which corresponds to the widest possible SOC range in which CC or CP mode can be maintained. However, it is also possible to cycle the battery in some arbitrary, narrower SOC range, provided that SOC is determined accurately and consistently, and that each charging/discharging cycle is performed over the same SOC range while maintaining either CC or CP mode during the entire cycle.

Step B

It is known in the art that the electrochemistry of the batteries is rather complex. During battery charging or discharging, a part of the energy is converted into the pure Joule heat and a part is lost in the electrochemical processes as well, as described in reference 9)

9) Gatta, F. M., Geri, A., Lauria, S., Maccioni, M., & Palone, F. (2015). Battery energy storage efficiency calculation including auxiliary losses: Technology comparison and operating strategies. 2015 IEEE Eindhoven PowerTech. doi:10.1109/ptc.2015.7232464

According to the proposed method, the determination of multiple roundtrip battery efficiencies $\eta_{c,d}^{cycle}$, for $C \times D$ different pairs of charging and discharging C-rates or P-rates defined in step A, should be performed. For every performed cycle, the roundtrip efficiency per cycle $\eta_{c,d,j}^{cycle}$, for selected $c$, $d$ and $j$, is calculated as described below.

In case of the selected CC mode, from the extracted charge $C_{c,d,j}^{dis}$ and the injected charge $C_{c,d,j}^{ch}$ into the said battery, the roundtrip efficiency per cycle $\eta_{c,d,j}^{cycle}$ is calculated according to the formula:

$$\eta_{c,d,j}^{cycle} = \frac{C_{c,d,j}^{dis}}{C_{c,d,j}^{ch}}$$

The said charges $C_{c,d,j}^{ch}$ and $C_{c,d,j}^{dis}$ are obtained by numerical integration of the time-dependant charging current $I_{c,d,j}^{ch}(t)$ and the discharging current $I_{c,d,j}^{dis}(t)$ :

$$C_{c,d,j}^{ch} = \int I_{c,d,j}^{ch}(t) \cdot dt$$

$$C_{c,d,j}^{dis} = \int I_{c,d,j}^{dis}(t) \cdot dt$$

It should be noted that the currents $I_{c,d,j}^{ch}(t)$ and $I_{c,d,j}^{dis}(t)$ are logged by an external device or by an appropriate converter itself during every cycle.

Similarly, in case of the selected CP mode, from the extracted energy $E_{c,d,j}^{dis}$ and the injected energy $E_{c,d,j}^{ch}$ into the said battery, the roundtrip efficiency per cycle $\eta_{c,d,j}^{cycle}$ is calculated according to the formula:

$$\eta_{c,d,j}^{cycle} = \frac{E_{c,d,j}^{dis}}{E_{c,d,j}^{ch}}$$

The said energies $E_{c,d,j}^{ch}$ and $E_{c,d,j}^{dis}$ are obtained by numerical integration of the time-dependant charging power $P_{c,d,j}^{ch}(t)$ and the discharging power $P_{c,d,j}^{dis}(t)$ :

$$E_{c,d,j}^{ch} = \int P_{c,d,j}^{ch}(t) \cdot dt$$

$$E_{c,d,j}^{dis} = \int P_{c,d,j}^{dis}(t) \cdot dt$$

It should be noted that the powers $P_{c,d,j}^{ch}(t)$ and $P_{c,d,j}^{dis}(t)$ are logged by an external device or by an appropriate converter itself during every cycle.

Once the obtained roundtrip efficiencies per cycle $\eta_{c,d,j}^{cycle}$ are obtained in the desired mode, i.e., CC or CP mode, it is natural to be averaged for the same repetitive runs. The measured and calculated roundtrip efficiencies per cycle $\eta_{c,d,j}^{cycle}$ are averaged over the number of repetitions $J$ from step A, yielding the roundtrip battery efficiencies $\eta_{c,d}^{cycle}$ for selected $C$ and $D$ values to read:

$$\eta_{c,d}^{cycle} = \frac{\sum_{j=1}^{J} \eta_{c,d,j}^{cycle}}{J}$$

The roundtrip battery efficiencies $\eta_{c,d}^{cycle}$ are the values that reflect historical efficiency for battery cycling data, i.e., for particular $\{c, d\}$ pairs of values. This value is not of particular use because the charging and discharging data are incorporated therein.

Step C

The inventive part of this disclosure is calculation of the one-way battery efficiencies, one-way charging efficiencies $\eta_c^{ch}$ and one-way discharging efficiencies $\eta_d^{dis}$ from the set of roundtrip battery efficiencies $\eta_{c,d}^{cycle}$ measured and calculated in step B.

The problem leads to the nonlinear optimisation problem which contains $C + D$ unknowns and $C \times D$ equations:

$$Minimize \sum_{c\in\Omega^C} \sum_{d\in\Omega^D} s_{c,d}^2$$

subjected to the following constrains:

$$\eta_c^{ch} \cdot \eta_d^{dis} = \eta_{c,d}^{cycle} + s_{c,d} \qquad \forall c \in \Omega^C, d \in \Omega^D$$

$$0 \le \eta_c^{ch} \le 1, \forall\, c \in \Omega^C$$

$$0 \le \eta_d^{dis} \le 1, \forall\, d \in \Omega^D$$

wherein $s_{c,d}$ is a slack variable. The solution of the above said optimisation problem gives $\eta_c^{ch}$ and $\eta_d^{dis}$ multiplication of which diverges from the measured efficiency $\eta_{c,d}^{cycle}$ the least - for every selected $\{c, d\}$ pair of values. It is important to note that the following assumption is used:

$$\eta_c^{ch} \cdot \eta_d^{dis} = \eta_{c,d}^{cycle} \; .$$

Once the one-way charging efficiencies $\eta_c^{ch}$ and one-way discharging efficiencies $\eta_d^{dis}$ for all measured / selected $\{c, d\}$ pairs are known, the battery is fully mapped and the results are ready to be used for everyday battery operation. Figure 1A shows charging one-way efficiencies $\eta_c^{ch}$, measured and calculated in three points, for the given environmental temperature $T^E$ vs. gross current (power) taken from the external source $i^{ch}$ ($p^{ch}$) corresponding to the selected charging C-rate (P-rate). Figure 1B shows discharging one-way efficiencies $\eta_d^{dis}$, measured and calculated in three points, for the given environmental temperature $T^E$ vs. net current (power) delivered to the external sink $i^{dis}$ ($p^{dis}$) corresponding to the selected discharging C-rate (P-rate).

The applications of the one-way efficiencies $\eta_c^{ch}$ and $\eta_d^{dis}$ are discussed in the following examples.

Example 1 - determination of state-of-charge *SOC* vector

If the battery cycling was performed in the CC mode, the obtained one-way efficiencies $\eta_c^{ch}$ and $\eta_d^{dis}$ can be used to determine the state-of-charge *SOC* vector. The procedure is explained in more detail below.

Previously calculated charging $\eta_c^{ch}$ and discharging $\eta_d^{dis}$ efficiencies in step C for the given battery are used for defining piecewise linear efficiency characteristics $\eta^C$ and $\eta^D$ for the range of battery's operational charging/discharging C-rates.

The said efficiency characteristics are defined as:

$$\hat{\imath}^{ch} = \eta^C\left(i^{ch}\right) \ \text{and} \ \hat{\imath}^{dis} = \eta^D\left(i^{dis}\right)$$

where $\hat{\imath}^{ch}$ is a net current injected in the battery during charging and it is function of the gross current taken from the external source $i^{ch}$, while gross current extracted from the battery during discharging $\hat{\imath}^{dis}$ is a function of the net current delivered to the external sink $i^{dis}$.

The functions $\eta^C$ and $\eta^D$ are obtained as interpolations or extrapolations performed for the measured currents $i^{ch}$, $i^{dis}$ values in respect to the known currents used in battery cycling in step A. Although many different methods can be used for reconstruction of $\eta^C$ and $\eta^D$ as continuous functions, e.g., spline reconstruction or similar, the present disclosure will use a simple piecewise linear interpolation, which turns to be sufficiently accurate for the desired task.

To perform the desired tasks, some changes in notation are applied to read the same regardless of the used mode, i.e., CC or CP mode. In the CC mode, $H_c^{ch}$ represents a selected $c$ charging value $i_c^{ch}$ of C-rates from step A and $G_c^{ch}$ its corrected value $\hat{\imath}_c^{ch}$ for the one-way charging efficiency $\eta_c^{ch}$ obtained from step C:

$$G_c^{ch} = \eta_c^{ch} \cdot H_c^{ch}, \quad \forall c \in \Omega^C \ .$$

Similarly, $H_d^{dis}$ represents a selected $d$ discharging value $i_d^{dis}$ of C-rates from step A and $G_d^{dis}$ its corrected value $\hat{\imath}_d^{dis}$ for the discharging efficiency $\eta_d^{dis}$ obtained in step C:

$$G_d^{dis} = \frac{H_d^{dis}}{\eta_d^{dis}}, \ \forall d \in \Omega^D \ .$$

Now, the said interpolations and extrapolations read:

$$\eta^C\left(i^{ch}\right) = \begin{cases} \dfrac{G_1^{ch}}{H_1^{ch}} \cdot i^{ch}, \text{if } i^{ch} \leq H_1^{ch} \\ G_c^{ch} + \dfrac{G_{c+1}^{ch} - G_c^{ch}}{H_{c+1}^{ch} - H_c^{ch}} \cdot \left(i^{ch} - H_c^{ch}\right), \text{if } H_c^{ch} < i^{ch} \leq H_{c+1}^{ch}, \text{for } c = 1,2\ldots C-1 \\ G_c^{ch} + \dfrac{G_c^{ch} - G_{c-1}^{ch}}{H_c^{ch} - H_{c-1}^{ch}} \cdot \left(i^{ch} - H_c^{ch}\right), \ \text{if } H_c^{ch} < i^{ch}, \text{for } c = C \end{cases}$$

and

$$\eta^D\left(i^{dis}\right) = \begin{cases} \dfrac{G_1^{dis}}{H_1^{dis}} \cdot i^{dis}, \text{if } i^{dis} \leq H_1^{dis} \\ G_d^{dis} + \dfrac{G_{d+1}^{dis} - G_d^{dis}}{H_{d+1}^{dis} - H_d^{dis}} \cdot \left(i^{dis} - H_d^{dis}\right), \text{if } H_d^{dis} < i^{dis} \leq H_{d+1}^{dis}, \text{for } d = 1\ldots D-1 \\ G_d^{dis} + \dfrac{G_d^{dis} - G_{d-1}^{dis}}{H_d^{dis} - H_{d-1}^{dis}} \cdot \left(i^{dis} - H_d^{dis}\right), \ \text{if } H_d^{dis} < i^{dis}, \text{for } d = D \end{cases}$$

The obtained functions $\eta^C(i^{ch})$ and $\eta^D(i^{dis})$ above are continuous functions of any selected gross charging and net discharging measured currents $i^{ch}$, $i^{dis}$, as shown in Figures 2A and 2B. Said relations are now used for calculation of state-of-charge SOC vector for the time series $t$, $SOC = (soc_0, soc_1, \ldots, soc_{t-1}, soc_t, \ldots)$.

It is possible to calculate each vector element value $soc_t$ at some time instant $t$, with respect to the previous $soc_{t-1}$ value which is known for the time interval $\Delta t$ that occurred just before the time instant $t$, by using the definition:

$$soc_t = soc_{t-1} + \Delta t \cdot \hat{\imath}_t^{ch} - \Delta t \cdot \hat{\imath}_t^{dis} \qquad \qquad \forall t \in \Omega^T$$

and by using the said relations $\hat{\imath}_t^{ch} = \eta^C(i_t^{ch})$ and $\hat{\imath}_t^{dis} = \eta^D(i_t^{dis})$.

Example 2 - determination of battery charge capacity $C^I$

The data obtained in Example 1 and the experimental determination of battery parameters, expressed in steps A-C, are used hereby for experimental determination of the battery charge capacity $C^I$. For the mentioned task, the following steps D and E are performed:

Step D

First, it is necessary to select $K$ number of different $C$-rates to perform $K$ full charging-discharging cycles in the constant-current-constant-voltage mode. It is desirable that $K$ is greater than 1 for improving the method accuracy, but the procedure is possible to be carried out even for $K$=1. The provisions or conditions are set below:

(i) the selected $C$-rate remains the same within the same cycle for charging and discharging,
(ii) the cycle is started with either fully depleted battery or fully charged battery, where fully depleted means that a battery is discharged until the discharge current drops below the defined low cut-off value, while keeping the battery's voltage at the low voltage limit, and fully charged means that a battery is charged until the charge current drops below the defined low cut-off value while keeping the battery's voltage at the high voltage limit, and
(iii) each charging is terminated when a battery is fully charged, while each discharging is terminated when a battery is fully depleted, as defined in (ii).

Step E

For every full cycle performed in step D the logged currents $i_t^{ch}$ and $i_t^{dis}$ are corrected with the results obtained in Example 1 by using charging $\eta^C$ and discharging $\eta^D$ efficiency characteristics, to obtain currents $\hat{\imath}_t^{ch}$ and $\hat{\imath}_t^{dis}$. Said values are integrated in time to obtain $K$ injected charges $C_k^{batt,ch}$ and $K$ extracted charges $C_k^{batt,dis}$ from the battery, where the obtained charges are averaged to calculate the newly defined, mean battery charge capacity:

$$C^I = \frac{\sum_{k=1}^{K} C_k^{batt,ch} + \sum_{k=1}^{K} C_k^{batt,dis}}{2 \cdot K}$$

Example 3 - determination of state of health $SOH$ parameter

Results obtained in previous examples can be used for determination of state of health $SOH$ parameter expressed in percentage 0-100%. Namely, $SOH$ is a time-dependent parameter defined as $SOH_t = C_t^I / C_0^I$. Parameter $C_0^I$ corresponds to the first determination of the mean battery charge capacity $C^I$ according to the Example 2 procedure when the battery is new, and $C_t^I$ is a newly determined value $C^I$ during the battery usage period according to the same procedure.

Now, the Examples 1-3 teaching for the constant current (CC) mode can be simply rewritten for the constant power (CP) mode, offering the power/energy approach instead of the current/charge approach.

Example 4 - determination of state-of-energy $SOE$ vector

If the battery cycling was performed in the CP mode, the obtained one-way efficiencies $\eta_c^{ch}$ and $\eta_d^{dis}$ can be used to determine the state-of-energy $SOE$ vector. The procedure is explained in more detail below.

Previously calculated charging $\eta_c^{ch}$ and discharging $\eta_d^{dis}$ efficiencies in step C for the given battery are used for defining piecewise linear efficiency characteristics $\eta^C$ and $\eta^D$ for the range of battery's operational charging/discharging $P$-rates.

The said efficiency characteristics are defined as:

$$\hat{p}^{ch} = \eta^C\left(p^{ch}\right) \text{ and } \hat{p}^{dis} = \eta^D\left(p^{dis}\right)$$

where $\hat{p}^{ch}$ is the net power injected in the battery during charging and it is function of gross power taken from an external source $p^{ch}$, while the gross power extracted from the battery during discharging $\hat{p}^{dis}$ is a function of net power delivered to an external sink $p^{dis}$.

The functions $\eta^C$ and $\eta^D$ are obtained as the interpolations or extrapolations performed for measured powers $p^{ch}$, $p^{dis}$ values in respect to the known powers used in battery cycling in step A. Although many different methods can be used for reconstruction of $\eta^C$ and $\eta^D$ as continuous functions, e.g., spline reconstruction or similar, the present disclosure will use a simple piecewise linear interpolation, which turns to be sufficiently accurate for the desired task.

To perform the desired tasks, some changes in notation are applied to read the same regardless of the used mode, i.e., CC or CP mode. In the CP mode, $H_c^{ch}$ represents a selected $c$ charging value $p_c^{ch}$ of $P$-rates from step A and $G_c^{ch}$ its corrected value $\hat{p}_c^{ch}$ for the one-way charging efficiency $\eta_c^{ch}$ obtained from step C:

$$G_c^{ch} = \eta_c^{ch} \cdot H_c^{ch}, \quad \forall c \in \Omega^C .$$

Similarly, $H_d^{dis}$ represents a selected $d$ discharging value $p_d^{dis}$ of $P$-rates from step A and $G_d^{dis}$ its corrected value $\hat{p}_d^{dis}$ for the discharging efficiency $\eta_d^{dis}$ obtained in step C:

$$G_d^{dis} = \frac{H_d^{dis}}{\eta_d^{dis}}, \ \forall d \in \Omega^D .$$

Now, the said interpolations and extrapolations read:

$$\eta^C\left(p^{ch}\right) = \begin{cases} \dfrac{G_1^{ch}}{H_1^{ch}} \cdot p^{ch}, \text{if } p^{ch} \leq H_1^{ch} \\ G_c^{ch} + \dfrac{G_{c+1}^{ch} - G_c^{ch}}{H_{c+1}^{ch} - H_c^{ch}} \cdot \left(p^{ch} - H_c^{ch}\right), \text{if } H_c^{ch} < p^{ch} \leq H_{c+1}^{ch}, \text{for } c = 1,2 \dots C - 1 \\ G_c^{ch} + \dfrac{G_c^{ch} - G_{c-1}^{ch}}{H_c^{ch} - H_{c-1}^{ch}} \cdot \left(p^{ch} - H_c^{ch}\right), \ \text{if } H_c^{ch} < p^{ch}, \text{for } c = C \end{cases}$$

and

$$\eta^D\left(p^{dis}\right) = \begin{cases} \dfrac{G_1^{dis}}{H_1^{dis}} \cdot p^{dis}, \text{if } p^{dis} \leq H_1^{dis} \\ G_d^{dis} + \dfrac{G_{d+1}^{dis} - G_d^{dis}}{H_{d+1}^{dis} - H_d^{dis}} \cdot \left(p^{dis} - H_d^{dis}\right), \text{if } H_d^{dis} < p^{dis} \leq H_{d+1}^{dis}, \text{for } d = 1 \dots D - 1 \\ G_d^{dis} + \dfrac{G_d^{dis} - G_{d-1}^{dis}}{H_d^{dis} - H_{d-1}^{dis}} \cdot \left(p^{dis} - H_d^{dis}\right), \ \text{if } H_d^{dis} < p^{dis}, \text{for } d = D \end{cases}$$

The obtained functions $\eta^C(p^{ch})$ and $\eta^D(p^{dis})$ above are continuous functions of any selected gross charging and net discharging measured powers $p^{ch}$, $p^{dis}$, as shown in Figures 2A and 2B. Said relations are now used for calculation of state-of-energy $SOE$ vector for the time series $t$, $SOE = (soe_0, soe_1, \dots , soe_{t-1}, soe_t, \dots)$.

It is possible to calculate each vector element value $soe_t$, at some time instant $t$, with respect to the previous $soe_{t-1}$ value which is known for the time interval $\Delta t$ that occurred just before the time instant $t$, by using the definition:

$$soe_t = soe_{t-1} + \Delta t \cdot \hat{p}_t^{ch} - \Delta t \cdot \hat{p}_t^{dis} \qquad \forall t \in \Omega^T$$

and by using the said relations $\hat{p}_t^{ch} = \eta^C\left(p_t^{ch}\right)$ and $\hat{p}_t^{dis} = \eta^D\left(p_t^{dis}\right)$.

Example 5 - determination of battery energy capacity $C^E$

The data obtained in Example 4 and the experimental determination of battery parameters, expressed in steps A-C, are used hereby for experimental determination of the battery energy capacity $C^E$. For the mentioned task, the following steps D and E are performed:

Step D

First, it is necessary to select $K$ number of different $P$-rates to perform $K$ full charging-discharging cycles in the constant-power-constant-voltage mode. It is desirable that $K$ is greater than 1 for improving the method accuracy, but the procedure is possible to be carried out even for $K$=1. The provisions or conditions are set below:

(i) the selected $P$-rate remains the same within the same cycle for charging and discharging,
(ii) the cycle is started with either a fully depleted battery or a fully charged battery, where fully depleted means that a battery is discharged until the discharge current drops below the defined low cut-off value, while keeping the battery's voltage at the low voltage limit, and fully charged means that a battery is charged until the charge current drops below the defined low cut-off value while keeping the battery's voltage at the high voltage limit, and
(iii) each charging is terminated when a battery is fully charged, while each discharging is terminated when a battery is fully depleted, as defined in (ii).

Step E

For every full cycle performed in step D the logged powers $p_t^{ch}$ and $p_t^{dis}$ are corrected with the results obtained in Example 4 by using charging $\eta^C$ and discharging $\eta^D$ efficiency characteristics, to obtain powers $\hat{p}_t^{ch}$ and $\hat{p}_t^{dis}$. Said values are integrated in time to obtain $K$ injected energies $E_k^{batt,ch}$ and $K$ extracted energies $E_k^{batt,dis}$, where the obtained energies are averaged to calculate the newly defined, mean battery energy capacity:

$$C^E = \frac{\sum_{k=1}^{K} E_k^{batt,ch} + \sum_{k=1}^{K} E_k^{batt,dis}}{2 \cdot K}$$

Example 6 - determination of state of health $SOH$ parameter

Results obtained in previous examples 4 and 5 can be used for determination of the state of health $SOH$ parameter expressed in percentage 0-100%. Namely, $SOH$ is a time-dependent parameter defined as $SOH_t = C_t^E / C_0^E$. Parameter $C_0^E$ corresponds to the first determination of the mean battery energy capacity $C^E$ according to the Example 5 procedure when the battery is new, and $C_t^E$ is a newly determined value $C^E$ during the battery usage period according to the same procedure.

Example 7 - an hour ahead energy charging ability

Thera are many possible uses of the before mentioned data. However, it is common in the field to perform an estimation of hour ahead energy charging ability for the instant $SOE$, when charging with a given $P$-rate. This approach is frequently used when it is necessary to maximize profit by performing energy arbitrage. The battery storage is a price taker and cannot affect market prices, which are known or forecast in advance. The simplest objective function of the proposed model is:

$$Maximize \sum_{t\in\Omega^T} \lambda_t \cdot (p_t^{dis} - p_t^{ch}) \cdot \Delta t$$

where $\lambda_t$ are hourly market prices, $p_t^{dis} \cdot \Delta t$ is the energy sold in the market and $p_t^{ch} \cdot \Delta t$ is the energy purchased in the market for the selected time $\Delta t$. Example 4 connects the mentioned real-world values with the real battery values, previously calculated and modeled to read:

$$soe_t = soe_{t-1} + \Delta t \cdot \hat{p}_t^{ch} - \Delta t \cdot \hat{p}_t^{dis} \qquad \forall t \in \Omega^T$$

$$\hat{p}_t^{ch} = \eta^C(p_t^{ch}) \ \text{and} \ \hat{p}_t^{dis} = \eta^D(p_t^{dis}).$$

Without going into details, a person skilled in the art will immediately recognize that the maximization results take the obtained efficiency characteristics $\eta^C$ and $\eta^D$ into account. Therefore, the optimization algorithm might suggest prolonging charging/discharging to non-peak energy price hours, if that results in a higher overall profit due to the reduced charging/discharging rates and consequently reduced energy losses. The model should also obey some constraints such as maximum charging/discharging $P$-rates the battery can sustain without being damaged. More complex models would include the battery amortisation, *SOH* calculations, and other relevant parameters to obtain the total costs of energy arbitrage performed with the modeled battery pack.

Example 8 - temperature variations

Figures 2A and 2B represent one-way efficiency characteristics $\eta^C$ and $\eta^D$ determined for a given battery pack, for some constant environmental temperature $T^E$. The same figures show measured pairs denoted as the solid dots; in case of the CP mode $\{p_t^{ch}, \hat{p}_t^{ch}\}$ and $\{p_t^{dis}, \hat{p}_t^{dis}\}$, or in case of the CC mode $\{i_t^{ch}, \hat{i}_t^{ch}\}$ and $\{i_t^{dis}, \hat{i}_t^{dis}\}$. Extrapolations and interpolations are denoted by the dashed and solid lines, while the "ideal battery" line is denoted by the dotted line where one-way efficiencies $\eta_c^{ch}$ and $\eta_d^{dis}$ are 1, i.e., the battery with 100% one-way efficiencies $\eta_c^{ch}$ and $\eta_d^{dis}$.

A change in environmental temperature $T^E$ causes slight changes in one-way efficiencies $\eta^C$ and $\eta^D$ and produces family of curves that deviate from those presented in Figures 2A, 2B. Such changes are described well in reference 1) cited in the state-of-art section.

Therefore, a person skilled in the art will, with reasonable experimentation effort, perform the experiments to obtain a family of curves $\eta^C, \eta^D$ which are, inter alia, battery temperature $T^{Bat}$ dependent as any other electrochemical process, or simply environmental temperature $T^E$ depended.

In a straightforward manner, these findings can be applied, *mutatis mutandis*, to all examples previously discussed.

**Industrial Applicability**

An industrial applicability of the present disclosure is obvious. Namely, the present disclosure reveals a novel method for experimental determination of battery parameters and their use for SOE (State of Energy), SOC (State od Charge) and SOH (State of Health) calculations for a given battery. The present disclosure also discusses the subsequent use of the mentioned values in everyday battery applications.

**Definitions and abbreviations**

$T^E$ - environmental temperature,
$T^{Bat}$ -measured battery temperature
CC - constant current mode,
CP - constant power mode,
$C$ - total number of different charging values used to conduct battery cycling for one-way efficiency determination purposes, (for CC denotes *C*-rate, for CP denotes *P*-rate),

*D* - total number of different discharging values used to conduct battery cycling for one-way efficiency determination purposes, (for CC denotes *C*-rate, for CP denotes *P*-rate),

*J* - cycling repetition number for one-way efficiency determination purposes,

$\Omega^C = \{c_1, c_2, \ldots, c_C\}$ - set of selected *C* values,

$\Omega^D = \{d_1, d_2, \ldots, d_D\}$ - set of selected *D* values,

$\eta_{c,d,j}^{cycle}$ - measured roundtrip efficiency per cycle,

$\eta_{c,d}^{cycle} = \dfrac{\sum_{j=1}^{J} \eta_{c,d,j}^{cycle}}{J}$ averaged roundtrip battery efficiency over J repetitions,

$\eta_c^{ch}$ - calculated (discrete) one-way charging efficiency corresponding to *c* charging *C*-rate (or *P*-rate),

$\eta_d^{dis}$ - calculated (discrete) one-way discharging efficiency corresponding to *d* discharging *C*-rate (or *P*-rate),

$\eta_{c,d,j}^{cycle} = \dfrac{C_{c,d,j}^{dis}}{C_{c,d,j}^{ch}}$ - roundtrip efficiency per cycle in CC mode,

$C_{c,d,j}^{ch} = \int I_{c,d,j}^{ch}(t) \cdot dt$ - the injected charge into the battery,

$C_{c,d,j}^{dis} = \int I_{c,d,j}^{dis}(t) \cdot dt$ - the extracted charge from the battery,

$I_{c,d,j}^{ch}(t)$ - logged charging current,

$I_{c,d,j}^{dis}(t)$ - logged discharging current,

$\eta_{c,d,j}^{cycle} = \dfrac{E_{c,d,j}^{dis}}{E_{c,d,j}^{ch}}$ - roundtrip efficiency per cycle in CP mode,

$E_{c,d,j}^{ch} = \int P_{c,d,j}^{ch}(t) \cdot dt$ - the injected power into the battery,

$E_{c,d,j}^{dis} = \int P_{c,d,j}^{dis}(t) \cdot dt$ - the extracted power from the battery,

$P_{c,d,j}^{ch}(t)$ - logged charging power,

$P_{c,d,j}^{dis}(t)$ - logged discharging power,

$\eta^C$ - piecewise linear efficiency charging characteristic,

$\eta^D$ - piecewise linear efficiency discharging characteristic,

In CC mode:

$\hat{\imath}^{ch} = \eta^C(i^{ch})$ - net current injected in the battery during charging,

$i^{ch}$ - gross current taken from the external source,

$\hat{\imath}^{dis} = \eta^D(i^{dis})$ - gross current extracted from the battery during discharging,

$i^{dis}$ - net current delivered to the external sink,

In CP mode:

$\hat{p}^{ch} = \eta^C(p^{ch})$ - net power injected in the battery during charging,

$\hat{p}^{ch}$ - gross power taken from the external source,

$\hat{p}^{dis} = \eta^D(p^{dis})$ - gross power extracted from the battery during discharging,

$p^{dis}$ - net power delivered to the external sink,

$$G_c^{ch} = \eta_c^{ch} \cdot H_c^{ch}$$ ; *c* - charging value for selected *C*-rate or *P*-rate

$H_c^{ch}$ - stands for $i_c^{ch}$ in CC mode,

$G_c^{ch}$ - stands for $\hat{\imath}_c^{ch}$ in CC mode,

$H_c^{ch}$ - stands for $p_c^{ch}$ in CP mode,

$G_c^{ch}$ - stands for $\hat{p}_c^{ch}$ in CP mode,

$$G_d^{dis} = H_d^{dis} / \eta_d^{dis}$$ ; *d* - discharging value for selected *C*-rate or *P*-rate

$H_d^{dis}$ - stands for $i_d^{dis}$ in CC mode,

$G_d^{dis}$ - stands for $\hat{\imath}_d^{dis}$ in CC mode,

$H_d^{dis}$ - stands for $p_d^{dis}$ in CP mode,

$G_d^{dis}$ - stands for $\hat{p}_d^{dis}$ in CP mode,

$SOC = (soc_0, soc_1, \dots, soc_{t-1}, soc_t, \dots)$ - state of charge vector,

$$soc_t = soc_{t-1} + \Delta t \cdot \hat{\imath}_t^{ch} - \Delta t \cdot \hat{\imath}_t^{dis}$$ , $\forall t \in \Omega^T$,

$SOE = (soe_0, soe_1, \dots, soe_{t-1}, soe_t, \dots)$ - state of energy vector,

$$soe_t = soe_{t-1} + \Delta t \cdot \hat{p}_t^{ch} - \Delta t \cdot \hat{p}_t^{dis}$$ , $\forall t \in \Omega^T$,

*K* - number of cycles with different C-rates (P-rates) for battery capacity determination purposes,

$$C^I = \frac{\sum_{k=1}^{K} C_k^{batt,ch} + \sum_{k=1}^{K} C_k^{batt,dis}}{2 \cdot K}$$ - measured mean battery charge capacity,

$$C^E = \frac{\sum_{k=1}^{K} E_k^{batt,ch} + \sum_{k=1}^{K} E_k^{batt,dis}}{2 \cdot K}$$ - measured mean battery energy capacity,

$C_k^{batt,ch}$ - time integrated $\hat{\imath}_t^{ch}$ in *k*-th cycle,

$C_k^{batt,dis}$ - time integrated $\hat{\imath}_t^{dis}$ in *k*-th cycle,

$E_k^{batt,ch}$ - time integrated $\hat{p}_t^{ch}$ in *k*-th cycle,

$E_k^{batt,dis}$ - time integrated $\hat{p}_t^{dis}$ in $k$-th cycle,

$SOH_t = C_t^I / C_0^I$ - state of health in later time $t$, based on battery charge capacity change with time,

$SOH_t = C_t^E / C_0^E$ - state of health in later time $t$, based on battery energy capacity change with time.

$\lambda_t$ - hourly market prices

**Claims**

1. A method for experimental determination of battery one-way efficiencies for a given environmental temperature $T^E$, where the said method comprising the following steps:

   A. executing a battery cycling protocol where charging and discharging are performed with an external source/sink, and where the said protocol is selected from the constant current (CC) or the constant power (CP) mode;

   - where at least two $C$ charging $C$-rates and at least two $D$ discharging $C$-rates are selected for the CC mode, where each $C$-rate denotes the measure of the rate at which a battery charges or discharges under constant current relative to its declared charge capacity, or
   - where at least two $C$ charging $P$-rates and at least two $D$ discharging $P$-rates are selected for the CP mode, where $P$-rate denotes the measure of the rate at which a battery charges or discharges under constant power relative to its declared energy capacity,

   where the selected set of all $\Omega^C = \{c_1, c_2, \ldots, c_C\}$ and $\Omega^D = \{d_1, d_2, \ldots, d_D\}$ values forms $C \times D$ charge-discharge cycles for all possible $\{c, d\}$ pairs of values, and where the above cycling is repeated $J$ times resulting in total of $C \times D \times J$ charge-discharge cycles, with the provision that:

   (i) each cycle is always started with a depleted battery, where depleted means that a non-depleted battery is discharged until the battery's low voltage limit has been reached with the provision that the discharging battery C-rate or P-rate is equal to the cycle's discharging C-rate or P-rate in step (iii), which will ensure the same starting and finishing point of the cycle in terms of currents and voltages,
   (ii) each charging in the CC mode or the CP mode is terminated as soon as the declared battery high voltage limit is reached,
   (iii) each discharging in the CC mode or the CP mode is terminated as soon as the declared battery low voltage limit is reached,

   where the said method is **characterized by:**

   B. determination of multiple roundtrip battery efficiencies $\eta_{c,d}^{cycle}$ for $C \times D$ different pairs of charging and discharging $C$-rates or $P$-rates defined in step A, where for every performed cycle the said roundtrip efficiency per cycle $\eta_{c,d,j}^{cycle}$, for selected $c$, $d$ and $j$, is calculated:

   - in case of the selected CC mode, from the extracted charge $C_{c,d,j}^{dis}$ and the injected charge $C_{c,d,j}^{ch}$ into the said battery:

$$\eta_{c,d,j}^{cycle} = \frac{C_{c,d,j}^{dis}}{C_{c,d,j}^{ch}}$$

where the said charges $C_{c,d,j}^{ch}$ and $C_{c,d,j}^{dis}$ are obtained by numerical integration of the time-dependant charging current $I_{c,d,j}^{ch}(t)$ and the discharging current $I_{c,d,j}^{dis}(t)$:

$$C_{c,d,j}^{ch} = \int I_{c,d,j}^{ch}(t) \cdot dt$$

$$C_{c,d,j}^{dis} = \int I_{c,d,j}^{dis}(t) \cdot dt$$

where the said currents $I_{c,d,j}^{ch}(t)$ and $I_{c,d,j}^{dis}(t)$ are logged during every cycle, or

- in case of the selected CP mode, from the extracted energy $E_{c,d,j}^{dis}$ and the injected energy $E_{c,d,j}^{ch}$ into the said battery:

$$\eta_{c,d,j}^{cycle} = \frac{E_{c,d,j}^{dis}}{E_{c,d,j}^{ch}}$$

where the said energies $E_{c,d,j}^{ch}$ and $E_{c,d,j}^{dis}$ are obtained by numerical integration of the time-dependant charging power $P_{c,d,j}^{ch}(t)$ and the discharging power $P_{c,d,j}^{dis}(t)$:

$$E_{c,d,j}^{ch} = \int P_{c,d,j}^{ch}(t) \cdot dt$$

$$E_{c,d,j}^{dis} = \int P_{c,d,j}^{dis}(t) \cdot dt$$

where the said powers $P_{c,d,j}^{ch}(t)$ and $P_{c,d,j}^{dis}(t)$ are logged during every cycle, and

where the obtained roundtrip efficiencies per cycle $\eta_{c,d,j}^{cycle}$ are averaged by the number of repetitions $J$ from step A, yielding the roundtrip battery efficiencies $\eta_{c,d}^{cycle}$ for selected $C$ and $D$ values to read:

$$\eta_{c,d}^{cycle} = \frac{\sum_{j=1}^{J} \eta_{c,d,j}^{cycle}}{J}$$

C. determination of one-way efficiencies from the calculated roundtrip battery efficiencies $\eta_{c,d}^{cycle}$ in step B, where $\eta_c^{ch}$ and $\eta_d^{dis}$ denote one-way charging and discharging efficiencies respectively, by solving the nonlinear optimisation problem which contains $C + D$ unknowns and $C \times D$ equations:

$$Minimize \sum_{c \in \Omega^C} \sum_{d \in \Omega^D} s_{c,d}^2$$

subjected to the following constrains:

$$\eta_c^{ch} \cdot \eta_d^{dis} = \eta_{c,d}^{cycle} + s_{c,d} \qquad \forall c \in \Omega^C, d \in \Omega^D$$

$$0 \le \eta_c^{ch} \le 1, \forall\, c \in \Omega^C$$

$$0 \le \eta_d^{dis} \le 1, \forall\, d \in \Omega^D$$

wherein $s_{c,d}$ is a slack variable, and where the solution of the above said optimisation problem gives $\eta_c^{ch}$ and $\eta_d^{dis}$, multiplication of which diverges from the measured efficiency $\eta_{c,d}^{cycle}$ the least for every selected {$c, d$} pair of values.

2. Use of the method for modelling battery one-way efficiency characteristics according to claim 1 in the CC mode for determination of the state-of-charge *SOC* vector, where the following steps are performed:

D. calculated charging $\eta_c^{ch}$ and discharging $\eta_d^{dis}$ efficiencies in step C for a given battery are used for defining piecewise linear efficiency characteristics $\eta^C$ and $\eta^D$ for the range of battery's operational charging/discharging C-rates, where the said efficiency characteristics are defined as:

$$\hat{\imath}^{ch} = \eta^C\left(i^{ch}\right) \ \text{and} \ \hat{\imath}^{dis} = \eta^D\left(i^{dis}\right)$$

where $\hat{\imath}^{ch}$ is the net current injected in the battery during charging and it is a function of the gross current taken from the external source $i^{ch}$, while the gross current extracted from the battery during discharging $\hat{\imath}^{dis}$ is a function of the net current delivered to the external sink $i^{dis}$,
E. where the functions $\eta^C$ and $\eta^D$ are obtained as interpolations or extrapolations performed for actual currents $i^{ch}$, $i^{dis}$ values in respect to known currents used in battery cycling in step A, preferably a linear interpolation, where $H_c^{ch}$ represents a selected *c* charging value of *C*-rates from step A and $G_c^{ch}$ its corrected value for the one-way charging efficiency $\eta_c^{ch}$ obtained from step C:

$$G_c^{ch} = \eta_c^{ch} \cdot H_c^{ch}, \quad \forall c \in \Omega^C,$$

where $H_d^{dis}$ represents a selected *d* discharging value of *C*-rates from step A and $G_d^{dis}$ its corrected value for the discharging efficiency $\eta_d^{dis}$ obtained in step C:

$$G_d^{dis} = \frac{H_d^{dis}}{\eta_d^{dis}}, \qquad \forall d \in \Omega^D$$

where the said interpolations and extrapolations read:

$$\eta^C\left(i^{ch}\right) = \begin{cases} \dfrac{G_1^{ch}}{H_1^{ch}} \cdot i^{ch}, \text{if } i^{ch} \leq H_1^{ch} \\[2ex] G_c^{ch} + \dfrac{G_{c+1}^{ch} - G_c^{ch}}{H_{c+1}^{ch} - H_c^{ch}} \cdot \left(i^{ch} - H_c^{ch}\right), \text{if } H_c^{ch} < i^{ch} \leq H_{c+1}^{ch}, \text{for } c = 1,2 \ldots C - 1 \\[2ex] G_c^{ch} + \dfrac{G_c^{ch} - G_{c-1}^{ch}}{H_c^{ch} - H_{c-1}^{ch}} \cdot \left(i^{ch} - H_c^{ch}\right), \text{ if } H_c^{ch} < i^{ch}, \text{for } c = C \end{cases}$$

and

$$\eta^D\left(i^{dis}\right) = \begin{cases} \dfrac{G_1^{dis}}{H_1^{dis}} \cdot i^{dis}, \text{if } i^{dis} \leq H_1^{dis} \\[2ex] G_d^{dis} + \dfrac{G_{d+1}^{dis} - G_d^{dis}}{H_{d+1}^{dis} - H_d^{dis}} \cdot \left(i^{dis} - H_d^{dis}\right), \text{if } H_d^{dis} < i^{dis} \leq H_{d+1}^{dis}, \text{for } d = 1 \ldots D - 1 \\[2ex] G_d^{dis} + \dfrac{G_d^{dis} - G_{d-1}^{dis}}{H_d^{dis} - H_{d-1}^{dis}} \cdot \left(i^{dis} - H_d^{dis}\right), \text{ if } H_d^{dis} < i^{dis}, \text{for } d = D \end{cases}$$

F. where the obtained $\eta^C(i^{ch})$ and $\eta^D(i^{dis})$ above, for any of the selected gross charging and net discharging measured currents $i^{ch}$, $i^{dis}$, are used for calculation of the state-of-charge $SOC$ vector for the time series $t$, $SOC = (soc_0, soc_1, \ldots, soc_{t-1}, soc_t, \ldots)$ where each vector element $soc_t$ at some time instant $t$ is calculated in respect to the previous $soc_{t-1}$ value known for the time interval $\Delta t$ that occurred just before time instant $t$ starting from the definition:

$$soc_t = soc_{t-1} + \Delta t \cdot \hat{i}_t^{ch} - \Delta t \cdot \hat{i}_t^{dis} \qquad\qquad \forall t \in \Omega^T$$

by using the relations $\hat{i}_t^{ch} = \eta^C\left(i_t^{ch}\right)$ and $\hat{i}_t^{dis} = \eta^D\left(i_t^{dis}\right)$.

3. Use of the method for modelling battery one-way efficiency characteristics according to claim 1 and 2 in the CC mode, for experimental determination of battery charge capacity $C^l$, where the following steps are performed:

G. selecting $K$ number of different $C$-rates to perform $K$ full charging-discharging cycles in the constant-current-constant-voltage mode, with the provisions that:

(i) the selected $C$-rate remains the same within the same cycle for charging and discharging,
(ii) the cycle is started with either fully depleted battery or fully charged battery, where fully depleted means that a battery is discharged until the discharge current drops below the defined low cut-off value, while keeping the battery's voltage at the low voltage limit, and fully charged means that a battery is charged until the charge current drops below the defined low cut-off value while keeping the battery's voltage at the high voltage limit, and
(iii) each charging is terminated when a battery is fully charged, while each discharging is terminated when a battery is fully depleted, as defined in (ii), and

H. for every full cycle performed in step G the logged currents $i_t^{ch}$ and $i_t^{dis}$ are corrected with the results obtained in step E by using charging $\eta^C$ and discharging $\eta^D$ efficiency characteristics, to obtain currents $\hat{i}_t^{ch}$ and $\hat{i}_t^{dis}$, which are integrated in time to obtain $K$ injected charges $C_k^{batt,ch}$ and $K$ extracted charges $C_k^{batt,dis}$, where the obtained charges are averaged to calculate the battery charge capacity:

$$C^I = \frac{\sum_{k=1}^{K} C_k^{batt,ch} + \sum_{k=1}^{K} C_k^{batt,dis}}{2 \cdot K}$$

4. Use of the method for modelling battery one-way efficiency characteristics according to claim 1 in the CP mode for determination of the state-of-energy *SOE* vector, where the following steps are performed:

D. calculated charging $\eta_c^{ch}$ and discharging $\eta_d^{dis}$ efficiencies in step C for the given battery are used for defining piecewise linear efficiency characteristics $\eta^C$ and $\eta^D$ for the range of battery's operational charging/-discharging P-rates, where the said efficiency characteristics are defined as:

$$\hat{p}^{ch} = \eta^C\left(p^{ch}\right) \text{ and } \hat{p}^{dis} = \eta^D\left(p^{dis}\right)$$

where $\hat{p}^{ch}$ is the net power injected in the battery during charging and it is a function of the gross power taken from the external source $p^{ch}$, while the gross power extracted from the battery during discharging $\hat{p}^{dis}$ is a function of the net power delivered to an external sink $p^{dis}$,

E. where the functions $\eta^C$ and $\eta^D$ are obtained as interpolations or extrapolations performed for actual powers $p^{ch}$, $p^{dis}$ values in respect to known powers used in battery cycling in step A, preferably a linear interpolation, where $H_c^{ch}$ represents a selected c charging value of *P*-rates from step A and $G_c^{ch}$ its corrected value for the one-way charging efficiency $\eta_c^{ch}$ obtained from step C:

$$G_c^{ch} = \eta_c^{ch} \cdot H_c^{ch}, \quad \forall c \in \Omega^C,$$

where $H_d^{dis}$ represents a selected *d* discharging value of *P*-rates from step A and $G_d^{dis}$ its corrected value for the discharging efficiency $\eta_d^{dis}$ obtained in step C:

$$G_d^{dis} = \frac{H_d^{dis}}{\eta_d^{dis}}, \qquad \forall d \in \Omega^D$$

where the said interpolations and extrapolations read:

$$\eta^C\left(p^{ch}\right) = \begin{cases} \dfrac{G_1^{ch}}{H_1^{ch}} \cdot p^{ch}, \text{if } p^{ch} \le H_1^{ch} \\[2mm] G_c^{ch} + \dfrac{G_{c+1}^{ch} - G_c^{ch}}{H_{c+1}^{ch} - H_c^{ch}} \cdot \left(p^{ch} - H_c^{ch}\right), \text{if } H_c^{ch} < p^{ch} \le H_{c+1}^{ch}, \text{for } c = 1,2 \dots C-1 \\[2mm] G_c^{ch} + \dfrac{G_c^{ch} - G_{c-1}^{ch}}{H_c^{ch} - H_{c-1}^{ch}} \cdot \left(p^{ch} - H_c^{ch}\right), \text{ if } H_c^{ch} < p^{ch}, \text{for } c = C \end{cases}$$

and

$$\eta^D\left(p^{dis}\right) = \begin{cases} \dfrac{G_1^{dis}}{H_1^{dis}} \cdot p^{dis}, \text{if } p^{dis} \le H_1^{dis} \\[2mm] G_d^{dis} + \dfrac{G_{d+1}^{dis} - G_d^{dis}}{H_{d+1}^{dis} - H_d^{dis}} \cdot \left(p^{dis} - H_d^{dis}\right), \text{if } H_d^{dis} < p^{dis} \le H_{d+1}^{dis}, \text{for } d = 1 \dots D-1 \\[2mm] G_d^{dis} + \dfrac{G_d^{dis} - G_{d-1}^{dis}}{H_d^{dis} - H_{d-1}^{dis}} \cdot \left(p^{dis} - H_d^{dis}\right), \text{ if } H_d^{dis} < p^{dis}, \text{for } d = D \end{cases}$$

F. where the obtained $\eta^C(p^{ch})$ and $\eta^D(p^{dis})$ above, for any of the selected gross charging and net discharging measured powers $p^{ch}$, $p^{dis}$, are used for calculation of the state-of-energy $SOE$ vector for the time series $t$, $SOE = (soe_0, soe_1, \ldots, soe_{t-1}, soe_t, \ldots)$ where each vector element $soe_t$ at some time instant $t$ is calculated in respect to the previous $soe_{t-1}$ value known for the time interval $\Delta t$ that occurred just before time instant $t$ starting from the definition:

$$soe_t = soe_{t-1} + \Delta t \cdot \hat{p}_t^{ch} - \Delta t \cdot \hat{p}_t^{dis} \qquad\qquad \forall t \in \Omega^T$$

by using the relations $\hat{p}_t^{ch} = \eta^C\left(p_t^{ch}\right)$ and $\hat{p}_t^{dis} = \eta^D\left(p_t^{dis}\right)$.

5. Use of the method for modelling battery one-way efficiency characteristics according to claim 1 and 4 in the CP mode, for experimental determination of battery energy capacity $C^E$, where the following steps are performed:

G. selecting $K$ number of different $P$-rates to perform $K$ full charging-discharging cycles in the constant-power-constant-voltage mode, with the provisions that:

(i) the selected $P$-rate remains the same within the same cycle for charging and discharging,
(ii) a cycle is started with either fully depleted battery or fully charged battery, where fully depleted means that a battery is discharged until the discharge current drops below the defined low cut-off value, while keeping the battery's voltage at the low voltage limit, and fully charged means that a battery is charged until the charge current drops below the defined low cut-off value while keeping the battery's voltage at the high voltage limit, and
(iii) each charging is terminated when a battery is fully charged, while each discharging is terminated when a battery is fully depleted, as defined in (ii), and

H. for every full cycle performed in step G the logged powers $p_t^{ch}$ and $p_t^{dis}$ are corrected with the results obtained in step E by using charging $\eta^C$ and discharging $\eta^D$ efficiency characteristics, to obtain powers $\hat{p}_t^{ch}$ and $\hat{p}_t^{dis}$, which are integrated in time to obtain $K$ injected energies $E_k^{batt,ch}$ and $K$ extracted energies $E_k^{batt,dis}$, where the obtained energies are averaged to calculate the battery energy capacity:

$$C^E = \frac{\sum_{k=1}^K E_k^{batt,ch} + \sum_{k=1}^K E_k^{batt,dis}}{2 \cdot K}$$

6. Use of the method for modelling battery one-way efficiency characteristics according to claim 4, where the $SOE$ vector for time series $t$ is used to estimate an hour ahead energy charging ability for the instant $SOE$, when charging with a given $P$-rate.

7. Use of the method for modelling battery one-way efficiency characteristics according to claim 3, for determination of the state of health $SOH$ parameter expressed in percentage 0-100%, where $SOH$ parameter in time is defined as $SOH_t = C_t^I / C_0^I$, and where $C_0^I$ corresponds with the first determination of mean battery charge capacity $C^I$ performed when the battery is new, and $C_t^I$ is a newly determined value $C^I$ during the battery usage period.

8. Use of the method for modelling battery one-way efficiency characteristics according to claim 5, for determination of the state of health $SOH$ parameter expressed in percentage 0-100%, where $SOH$ parameter in time is defined as $SOH_t = C_t^E / C_0^E$, and where $C_0^E$ corresponds with the first determination of mean battery energy capacity $C^E$ performed when the battery is new, and $C_t^E$ is a newly determined value $C^E$ during the battery usage period.

9. Use of the method for modelling battery one-way efficiency characteristics according to any of claims 2-8, where the method is performed for different environmental temperatures $T^E$.

**Patentansprüche**

1. Verfahren zur experimentellen Bestimmung von Einwegwirkungsgraden von Batterien bei einer gegebenen Umgebungstemperatur $T^E$, wobei das Verfahren die folgenden Schritte umfasst:

A. Ausführen eines Batteriezyklusprotokolls, wo Laden und Entladen mit einer externen Quelle/Senke durchgeführt werden, und wo das Protokoll aus dem Konstantstrom-, (CC)-, oder dem Konstantleistungs-, (CP)-, Modus ausgewählt wird;

- wo für den CC-Modus mindestens zwei $C$ Lade-$C$-Raten und mindestens zwei $D$- Entlade-$C$-Raten ausgewählt werden, wo jede $C$-Rate das Maß für die Rate bezeichnet, mit der eine Batterie bei konstantem Strom im Verhältnis zu ihrer angegebenen Ladekapazität geladen oder entladen wird, oder
- wobei für den CP-Modus mindestens zwei $C$ Lade-$P$-Raten und mindestens zwei $D$ Entlade-$P$-Raten ausgewählt werden, wo $P$-Rate die Rate bezeichnet, mit der eine Batterie bei konstanter Leistung im Verhältnis zu ihrer angegebenen Energiekapazität geladen oder entladen wird,

wo der ausgewählte Satz aller $\Omega^C = \{c_1, c_2, \ldots, c_C\}$ und $\Omega^D = \{d_1, d_2, \ldots, d_D\}$ Werte $C \times D$ Lade-Entlade-Zyklen für alle möglichen $\{c, d\}$ Wertepaare bildet und wo der obige Zyklus $J$ Mal wiederholt wird, was insgesamt $C \times D \times J$ Lade-Entlade-Zyklen ergibt, mit dem Vorbehalt, dass:

(i) jeder Zyklus stets mit einer leeren Batterie begonnen wird, wobei leer bedeutet, dass eine nicht-leere Batterie entladen wird, bis die untere Spannungsgrenze der Batterie erreicht ist, unter dem Vorbehalt, dass die C-Rate oder P-Rate der entladenden Batterie gleich der C-Rate oder P-Rate des Entladezyklus in Schritt (iii) ist, was hinsichtlich Strömen und Spannungen den gleichen Start- und Endpunkt des Zyklus sicherstellt,
(ii) jeder Ladevorgang in dem CC-Modus oder dem CP-Modus beendet wird, sobald die angegebene obere Spannungsgrenze der Batterie erreicht ist,
(iii) jedes Entladen in dem CC-Modus oder dem CP-Modus beendet wird, sobald die angegebene untere Spannungsgrenze der Batterie erreicht ist,

wo das genannte Verfahren **gekennzeichnet ist durch:**

B. Bestimmung mehrerer Roundtrip-Batteriewirkungsgrade $\eta_{c,d}^{Zyklus}$ für $C \times D$ verschiedene Paare von Lade- und Entlade-$C$-Raten oder $P$-Raten, die in Schritt A definiert wurden, wo für jeden durchgeführten Zyklus der genannte Roundtrip-Wirkungsgrad pro Zyklus $\eta_{c,d,j}^{Zyklus}$ für ausgewählte $c, d$ und $j$ wie folgt berechnet wird:

- im Falle des ausgewählten CC-Modus, aus der entnommenen Ladung $C_{c,d,j}^{dis}$ und der in die genannte Batterie eingespeisten Ladung $C_{c,d,j}^{ch}$:

$$\eta_{c,d,j}^{Zyklus} = \frac{C_{c,d,j}^{dis}}{C_{c,d,j}^{ch}}$$

wo die genannten Ladungen $C_{c,d,j}^{ch}$ und $C_{c,d,j}^{dis}$ **durch** numerische Integration des zeitabhängigen Ladestroms $I_{c,d,j}^{ch}(T)$ und des Entladestroms $I_{c,d,j}^{dis}(t)$: erhalten werden.

$$C_{c,d,j}^{ch} = \int I_{c,d,j}^{ch}(t) \cdot dt$$

$$C_{c,d,j}^{dis} = \int I_{c,d,j}^{dis}(t) \cdot dt$$

wobei die genannten Ströme $I_{c,d,j}^{ch}(t)$ und $I_{c,d,j}^{dis}(t)$ während jedes Zyklus aufgezeichnet werden, oder

- im Falle des ausgewählten CP-Modus, aus der entnommenen Energie $E_{c,d,j}^{dis}$ und der in die besagte Batterie eingespeisten Energie $E_{c,d,j}^{ch}$ :

$$\eta_{c,d,j}^{Zyklus} = \frac{E_{c,d,j}^{dis}}{E_{c,d,j}^{ch}}$$

wo die Energien $E_{c,d,j}^{ch}$ und $E_{c,d,j}^{dis}$ **durch** numerische Integration der zeitabhängigen Ladeleistung $P_{c,d,j}^{ch}(t)$ und der Entladeleistung $P_{c,d,j}^{dis}(t)$ erhalten werden:

$$E_{c,d,j}^{ch} = \int P_{c,d,j}^{ch}(t) \cdot dt$$

$$E_{c,d,j}^{dis} = \int P_{c,d,j}^{dis}(t) \cdot dt$$

wobei die genannten Leistungen $P_{c,d,j}^{ch}(t)$ und $P_{c,d,j}^{dis}(t)$ während jedes Zyklus aufgezeichnet werden, und

wo die erhaltenen Roundtrip-Wirkungsgrade pro Zyklus $\eta_{c,d,j}^{Zyklus}$ **durch** die Anzahl von Wiederholungen *J* aus Schritt A gemittelt werden, was ergibt, dass die Roundtrip-Batteriewirkungsgrade $\eta_{c,d}^{Zyklus}$ für ausgewählte *C* und *D*-Werte wie folgt lauten:

$$\eta_{c,d}^{Zyklus} = \frac{\sum_{j=1}^{J} \eta_{c,d,j}^{Zyklus}}{J}$$

C. Bestimmung der Einwegwirkungsgrade aus den berechneten Roundtrip-Batteriewirkungsgraden $\eta_{c,d}^{Zyklus}$

in Schritt B, wo $\eta_c^{ch}$ und $\eta_d^{dis}$ die Einweg-Lade- bzw. Entladewirkungsgrade bezeichnen, **durch** Lösen des nichtlinearen Optimierungsproblems, das *C + D* Unbekannte und *C* × *D* Gleichungen enthält:

$$Minimieren \sum_{c \in \Omega^C} \sum_{d \in \Omega^D} S_{c,d}^2$$

den folgenden Einschränkungen unterworfen:

$$\eta_c^{ch} \cdot \eta_d^{dis} = \eta_{c,d}^{Zyklus} + s_{c,d} \forall c \in \Omega^c, d \in \Omega^D$$

$$0 \le \eta_c^{ch} \le 1, \forall c \in \Omega^c$$

$$0 \le \eta_d^{dis} \le 1, \forall d \in \Omega^D$$

wobei $s_{c,d}$ eine Schlupfvariable ist und wo die Lösung des oben genannten Optimierungsproblems $\eta_c^{ch}$ und $\eta_d^{dis}$, ergibt, deren Multiplikation für jedes ausgewählte *{c, d}* Wertepaar am wenigsten von dem gemessenen Wirkungsgrad $\eta_{c,d}^{Zyklus}$ abweicht.

**2.** Verwendung des Verfahrens zum Modellieren von Einwegwirkungsgradeigenschaften von Batterien nach Anspruch 1 im CC-Modus zur Bestimmung des Ladezustands-, **SOC**-Vektors, wo folgende Schritte durchgeführt werden:

D. in Schritt C berechnete Lade- $\eta_c^{ch}$ und Entlade- $\eta_d^{dis}$ Wirkungsgrade für eine gegebene Batterie werden verwendet, um stückweise lineare Wirkungsgradeigenschaften $\eta^C$ und $\eta^D$ für den Bereich betriebsfähiger Lade/Entlade-*C*-Raten der Batterie zu definieren, wo die genannten Wirkungsgradeigenschaften wie folgt definiert sind:

$$\hat{\imath}^{ch} = \eta^C\left(i^{ch}\right) \text{und } \hat{\imath}^{dis} = \eta^D\left(i^{dis}\right)$$

wo $\hat{\imath}^{ch}$ der Nettostrom ist, der während Ladens in die Batterie eingespeist wird und eine Funktion des Bruttostroms $i^{ch}$ ist, der der externen Quelle entnommen wird, während der Bruttostrom $\hat{\imath}^{dis}$, der während Entladens der Batterie entnommen wird, eine Funktion des Nettostroms $i^{dis}$ ist, der an die externe Senke geliefert wird,
E. wo die Funktionen $\eta^C$ und $\eta^D$ als Interpolationen oder Extrapolationen erhalten werden, die für tatsächliche Stromwerte $i^{ch}$, $i^{dis}$ in Bezug auf bekannte Ströme durchgeführt werden, die beim Batteriezyklus in Schritt A verwendet werden, bevorzugt eine lineare Interpolation, wo $H_c^{ch}$ einen ausgewählten *c* Ladewert von *C*-Raten aus Schritt A darstellt und $G_c^{ch}$ seinen korrigierten Wert für den Einwegladewirkungsgrad $\eta_c^{ch}$ darstellt, der aus Schritt C erhalten wurde:

$$G_c^{ch} = \eta_c^{ch} \cdot H_c^{ch}, \forall c \in \Omega^c,$$

wo $H_d^{dis}$ einen ausgewählten d-Entladewert der *C*-Raten aus Schritt A und $G_d^{dis}$ seinen korrigierten Wert für den Entladewirkungsgrad $\eta_d^{dis}$ darstellt, der in Schritt C erhalten wurde:

$$G_d^{dis} = \frac{H_d^{dis}}{\eta_d^{dis}}, \forall d \in \Omega^D$$

wo die genannten Interpolationen und Extrapolationen wie folgt lauten:

$$\eta^c\left(i^{ch}\right)$$

$$= \begin{cases} \dfrac{G_1^{ch}}{H_1^{ch}} \cdot i^{ch}, \text{wenn } i^{ch} \leq H_1^{ch} \\[2ex] G_c^{ch} + \dfrac{G_{c+1}^{ch} - G_c^{ch}}{H_{c+1}^{ch} - H_c^{ch}} \cdot \left(i^{ch} - H_c^{ch}\right), \text{wenn } H_c^{ch} < i^{ch} \leq H_{c+1}^{ch}, \text{für } c = 1,2 \dots C-1 \\[2ex] G_c^{ch} + \dfrac{G_c^{ch} - G_{c-1}^{ch}}{H_c^{ch} - H_{c-1}^{ch}} \cdot \left(i^{ch} - H_c^{ch}\right), \text{wenn } H_c^{ch} < i^{ch}, \text{für } c = C \end{cases}$$

und

$$\eta^D(i^{dis}) = \begin{cases} \dfrac{G_1^{dis}}{H_1^{dis}} \cdot i^{dis}, \text{wenn } i^{dis} \leq H_1^{dis} \\[2ex] G_d^{dis} + \dfrac{G_{d+1}^{dis} - G_d^{dis}}{H_{d+1}^{dis} - H_d^{dis}} \cdot \left(i^{dis} - H_d^{dis}\right), \text{wenn } H_d^{dis} < i^{dis} \leq H_{d+1}^{dis}, \text{für } d = 1 \dots D-1 \\[2ex] G_d^{dis} + \dfrac{G_d^{dis} - G_{d-1}^{dis}}{H_d^{dis} - H_{d-1}^{dis}} \cdot \left(i^{dis} - H_d^{dis}\right), \text{wenn } H_d^{dis} < i^{dis}, \text{für } d = D \end{cases}$$

f) wo die oben erhaltenen $\eta^C(i^{ch})$ und $\eta^D(i^{dis})$ für einen beliebigen der ausgewählten gemessenen Bruttolade- und Nettoentladeströme $i^{ch}$, $i^{dis}$ zur Berechnung des Ladezustands-, $SOC$-Vektors für die Zeitreihe $t$, $SOC = (soc_0, soc_1, \dots , soc_{t-1}, soc_t, \dots)$ verwendet werden, wo jedes Vektorelement $soc_t$ zu einem bestimmten Zeitpunkt $T$ in Bezug auf den vorherigen $soc_{t-1}$ Wert berechnet wird, der für das Zeitintervall $\Delta t$ bekannt ist, das unmittelbar vor dem Zeitpunkt $t$ auftrat, ausgehend von der Definition:

$$soc_t = soc_{t-1} + \Delta t \cdot \hat{\imath}_t^{ch} - \Delta t \cdot \hat{\imath}_t^{dis} \forall t \in \Omega^T$$

unter Verwendung der Beziehungen

$$\hat{\imath}_t^{ch} = \eta^c\left(i_t^{ch}\right) \text{ und } \hat{\imath}_t^{dis} = \eta^D\left(i_t^{dis}\right).$$

3. Verwendung des Verfahrens zum Modellieren der Einwegwirkungsgradeigenschaften von Batterien nach Anspruch und 2 im CC-Modus zur experimentellen Bestimmung der Ladekapazität $C^1$ einer Batterie, wo die folgenden Schritte durchgeführt werden:

G. Auswählen einer $K$ Anzahl unterschiedlicher $C$-Raten, um $K$ vollständige Lade-Entlade-Zyklen im Konstantstrom-Konstantspannungsmodus durchzuführen, mit dem Vorbehalt, dass:

(i) die ausgewählte $C$-Rate innerhalb desselben Zyklus beim Laden und Entladen gleichbleibt,
(ii) der Zyklus entweder mit vollständig leerer oder vollständig geladener Batterie gestartet wird, wo vollständig leer bedeutet, dass eine Batterie entladen wird, bis der Entladestrom unter den definierten unteren Abschaltwert fällt, während die Batteriespannung an der unteren Spannungsgrenze gehalten wird, und vollständig geladen bedeutet, dass eine Batterie geladen wird, bis der Ladestrom unter den definierten unteren Abschaltwert fällt, während die Batteriespannung an der oberen Spannungsgrenze gehalten wird, und
(iii) jedes Laden beendet wird, wenn eine Batterie vollständig geladen ist, während jedes Entladen beendet wird, wenn eine Batterie vollständig leer ist, gemäß der Definition in (ii), und

H. für jeden in Schritt G durchgeführten vollständigen Zyklus die aufgezeichneten Ströme $i_t^{ch}$ und $i_t^{dis}$ mit den in Schritt E erhaltenen Ergebnissen unter Verwendung von Lade- $\eta^c$ und Entlade- $\eta^D$ Wirkungsgradeigenschaften korrigiert werden, um Ströme $\hat{\imath}_t^{ch}$ und $\hat{\imath}_t^{dis}$ zu erhalten, die über die Zeit integriert werden, um $K$ eingespeiste Ladungen $C_k^{batt,ch}$ und $K$ entnommene Ladungen $C_k^{batt,dis}$, zu erhalten, wo die erhaltenen Ladungen gemittelt werden, um die Ladekapazität der Batterie zu berechnen:

$$C^1 = \frac{\sum_{k=1}^{K} C_k^{batt,ch} + \sum_{k=1}^{K} C_k^{batt,dis}}{2 \cdot K}$$

**4.** Verwendung des Verfahrens zum Modellieren von Einwegwirkungsgradeigenschaften von Batterien nach Anspruch 1 im CP-Modus zur Bestimmung des Energiezustands **SOE**-Vektors, wo die folgenden Schritte durchgeführt werden:

D. in Schritt C berechnete Lade- $\eta_c^{ch}$ und Entlade- $\eta_d^{dis}$ Wirkungsgrade für eine gegebene Batterie werden verwendet, um stückweise lineare Wirkungsgradeigenschaften $\eta^C$ und $\eta^D$ für den Bereich betriebsfähiger Lade/Entlade-$P$-Raten der Batterie zu definieren, wo die genannten Wirkungsgradeigenschaften wie folgt definiert sind:

$$\hat{p}^{ch} = \eta^C\left(p^{ch}\right) \text{und } \hat{p}^{dis} = \eta^D\left(p^{dis}\right)$$

wo $\hat{p}^{ch}$ die Nettoleistung ist, die während des Ladens in die Batterie eingespeist wird und eine Funktion der Bruttoleistung $p^{ch}$ ist, die der externen Quelle entnommen wird, während die Bruttoleistung $\hat{p}^{dis}$, die während des Entladens der Batterie entnommen wird, eine Funktion der Nettoleistung $p^{dis}$ ist, die an die externe Senke geliefert wird,

E. wo die Funktionen $\eta^C$ und $\eta^D$ als Interpolationen oder Extrapolationen erhalten werden, die für tatsächliche Leistungswerte $p^{ch}$, $p^{dis}$ in Bezug auf bekannte Leistungen durchgeführt werden, die beim Batteriezyklus in Schritt A verwendet werden, bevorzugt eine lineare Interpolation, wo $H_c^{ch}$ einen ausgewählten $c$-Ladewert von $P$-Raten aus Schritt A darstellt und $G_c^{ch}$ seinen korrigierten Wert für den Einwegladewirkungsgrad $\eta_c^{ch}$ darstellt, der aus Schritt C erhalten wurde:

$$G_c^{ch} = \eta_c^{ch} \cdot H_c^{ch}, \forall c \in \Omega^C,$$

wo $H_d^{dis}$ einen ausgewählten $d$-Entladewert der P-Raten aus Schritt A und $G_d^{dis}$ seinen korrigierten Wert für den Entladewirkungsgrad $\eta_d^{dis}$ darstellt, der in Schritt C erhalten wurde:

$$G_d^{dis} = \frac{H_d^{dis}}{\eta_d^{dis}}, \forall d \in \Omega^D$$

wo die genannten Interpolationen und Extrapolationen wie folgt lauten:

$$\eta^c(p^{ch}) = \begin{cases} \frac{G_1^{ch}}{H_1^{ch}} \cdot p^{ch}, \text{wenn } p^{ch} \leq H_1^{ch} \\ G_c^{ch} + \frac{G_{c+1}^{ch} - G_c^{ch}}{H_{c+1}^{ch} - H_c^{ch}} \cdot (p^{ch} - H_c^{ch}), \text{wenn } H_c^{ch} < p^{ch} \leq H_{c+1}^{ch}, \text{für } c = 1,2 \dots C-1 \\ G_c^{ch} + \frac{G_c^{ch} - G_{c-1}^{ch}}{H_c^{ch} - H_{c-1}^{ch}} \cdot (p^{ch} - H_c^{ch}), \text{wenn } H_c^{ch} < p^{ch}, \text{für } c = C \end{cases}$$

und

$$\eta^D(p^{dis}) = \begin{cases} \dfrac{G_1^{dis}}{H_1^{dis}} \cdot p^{dis}, \text{wenn } p^{dis} \leq H_1^{dis} \\ G_d^{dis} + \dfrac{G_{d+1}^{dis} - G_d^{dis}}{H_{d+1}^{dis} - H_d^{dis}} \cdot \left(p^{dis} - H_d^{dis}\right), \text{wenn } H_d^{dis} < p^{dis} \leq H_{d+1}^{dis}, \text{für } d = 1 \dots D-1 \\ G_d^{dis} + \dfrac{G_d^{dis} - G_{d-1}^{dis}}{H_d^{dis} - H_{d-1}^{dis}} \cdot \left(p^{dis} - H_d^{dis}\right), \text{wenn } H_d^{dis} < p^{dis}, \text{für } d = D \end{cases}$$

F. wo die oben erhaltenen $\eta^C(p^{ch})$ und $\eta^D(p^{dis})$ für eine beliebige der ausgewählten gemessenen Bruttolade- und Nettoentladeleistungen $p^{ch}$, $p^{dis}$ zur Berechnung des Leistungszustands SOE-Vektors für die Zeitreihe $t$, $SOE$ = ($soe_0$, $soe_1$, ... , $soe_{t-1}$, $soe_t$, ...) verwendet werden, wo jedes Vektorelement $soe_t$ zu einem bestimmten Zeitpunkt $T$ in Bezug auf den vorherigen $soe_{t-1}$ Wert berechnet wird, der für das Zeitintervall $\Delta t$ bekannt ist, das unmittelbar vor dem Zeitpunkt $t$ auftrat, ausgehend von der Definition:

$$soe_t = soe_{t-1} + \Delta t \cdot \hat{p}_t^{ch} - \Delta t \cdot \hat{p}_t^{dis} \forall t \in \Omega^T$$

unter Verwendung der Beziehungen

$$\hat{p}_t^{ch} = \eta^c\left(p_t^{ch}\right) \text{ und } \hat{p}_t^{dis} = \eta^D\left(p_t^{dis}\right).$$

5. Verwendung des Verfahrens zum Modellieren der Einwegwirkungsgradeigenschaften von Batterien nach Anspruch 1 und 4 im CP-Modus zur experimentellen Bestimmung der Energiekapazität $C^E$ einer Batterie, wo die folgenden Schritte durchgeführt werden:

G. Auswählen einer $K$ Anzahl unterschiedlicher $P$-Raten, um $K$ vollständige Lade-Entlade-Zyklen im Konstantleistungs-Konstantspannungsmodus durchzuführen, mit dem Vorbehalt, dass:

(i) die ausgewählte $P$-Rate innerhalb desselben Zyklus beim Laden und Entladen gleichbleibt,
(ii) ein Zyklus entweder mit vollständig leerer oder vollständig geladener Batterie gestartet wird, wo vollständig leer bedeutet, dass eine Batterie entladen wird, bis der Entladestrom unter den definierten unteren Abschaltwert fällt, während die Batteriespannung an der unteren Spannungsgrenze gehalten wird, und vollständig geladen bedeutet, dass eine Batterie geladen wird, bis der Ladestrom unter den definierten unteren Abschaltwert fällt, während die Batteriespannung an der Hochspannungsgrenze gehalten wird, und
(iii) jedes Laden beendet wird, wenn eine Batterie vollständig geladen ist, während jedes Entladen beendet wird, wenn eine Batterie vollständig leer ist, gemäß der Definition in (ii), und

H. für jeden in Schritt G durchgeführten vollständigen Zyklus die aufgezeichneten Leistungen $p_t^{ch}$ und $p_t^{dis}$ mit den in Schritt E erhaltenen Ergebnissen unter Verwendung von Lade- $\eta^c$ und Entlade- $\eta^D$ Wirkungsgradeigenschaften korrigiert werden, um Leistungen $\hat{p}_t^{ch}$ und $\hat{p}_t^{dis}$ zu erhalten, die über die Zeit integriert werden, um $K$ eingespeiste Energien $E_k^{batt,ch}$ und K entnommene Energien $E_k^{batt,dis}$, zu erhalten, wo die erhaltenen Energien gemittelt werden, um die Energiekapazität der Batterie zu berechnen:

$$C^E = \frac{\sum_{k=1}^K E_k^{batt,ch} + \sum_{k=1}^K E_k^{batt,dis}}{2 \cdot K}$$

6. Verwendung des Verfahrens zum Modellieren von Einwegwirkungsgradeigenschaften einer Batterie nach Anspruch 4, wo der $SOE$-Vektor für die Zeitreihe $t$ verwendet wird, um die Energieladefähigkeit für den aktuellen $SOE$ für eine Stunde im Voraus zu schätzen, wenn mit einer gegebenen $P$-Rate geladen wird.

7. Verwendung des Verfahrens zum Modellieren der Einwegwirkungsgradeigenschaften einer Batterie nach Anspruch 3 zur Bestimmung des Gesundheitszustands-, $SOH$-Parameters in Prozent 0-100%, wo $SOH$-Parameter zeitlich als

$$SOH_t = C_t^I / C_0^I$$ definiert ist und wo $C_0^I$ der ersten Bestimmung der durchschnittlichen Batterieladekapazität $C^I$ entspricht, die durchgeführt wird, wenn die Batterie neu ist, und $C_t^I$ ein neu bestimmter Wert $C^I$ während der Nutzungsdauer der Batterie ist.

**8.** Verwendung des Verfahrens zum Modellieren der Einwegwirkungsgradeigenschaften einer Batterie nach Anspruch 5 zur Bestimmung des Gesundheitszustands-, *SOH*-Parameters in Prozent 0-100%, wo *SOH*-Parameter zeitlich als

$$SOH_t = C_t^E / C_0^E$$ definiert ist und wo $C_0^E$ der ersten Bestimmung der durchschnittlichen Batterieenergiekapazität $C^E$ entspricht, die durchgeführt wird, wenn die Batterie neu ist, und $C_t^E$ ein neu bestimmter Wert $C^E$ während der Nutzungsdauer der Batterie ist.

**9.** Verwendung des Verfahrens zum Modellieren der Einwegwirkungsgradeigenschaften einer Batterie nach einem der Ansprüche 2-8, wo das Verfahren für unterschiedliche Umgebungstemperaturen $T^E$ durchgeführt wird.

**Revendications**

**1.** Procédé de détermination expérimentale de rendements unidirectionnels de batterie pour une température ambiante donnée $T^E$, dans lequel ledit procédé comprend les étapes suivantes :

A. l'exécution d'un protocole de cyclage de batterie dans lequel la charge et la décharge sont effectuées avec une source/un puits externe, et dans lequel ledit protocole est sélectionné parmi le mode à courant constant (CC) ou à puissance constante (CP) ;

- dans lequel au moins deux taux *C* de charge *C* et au moins deux taux *C* de décharge *D* sont sélectionnés pour le mode CC, dans lequel chaque taux *C* désigne la mesure du taux auquel une batterie se charge ou se décharge sous courant constant par rapport à sa capacité de charge déclarée, ou
- dans lequel au moins deux taux *P* de charge *C* et au moins deux taux *P* de décharge *D* sont sélectionnés pour le mode CP, dans lequel le taux *P* désigne la mesure du taux auquel une batterie se charge ou se décharge sous puissance constante par rapport à sa capacité énergétique déclarée,

dans lequel l'ensemble sélectionné de toutes les valeurs $\Omega^C = \{c_1, c_2, \dots, c_C\}$ et $\Omega^D = \{d_1, d_2, \dots, d_D\}$ forme $C \times D$ cycles de charge-décharge pour toutes les paires de valeurs $\{c, d\}$ possibles, et dans lequel le cyclage ci-dessus est répété *J* fois, ce qui donne un total de $C \times D \times J$ cycles de charge-décharge, à condition que :

(i) chaque cycle soit toujours démarré avec une batterie déchargée, dans lequel déchargé signifie qu'une batterie non déchargée est déchargée jusqu'à ce que la limite de basse tension de la batterie soit atteinte, à condition que le taux C ou le taux P de décharge de batterie soit égal au taux C ou au taux P de décharge du cycle à l'étape (iii), ce qui garantira le même point de départ et de fin du cycle du point de vue des courants et des tensions,
(ii) chaque charge en mode CC ou en mode CP soit terminée dès que la limite de haute tension déclarée de batterie est atteinte,
(iii) chaque décharge en mode CC ou en mode CP soit terminée dès que la limite de basse tension déclarée de batterie est atteinte,

dans lequel ledit procédé est **caractérisé par :**

B. la détermination de multiples rendements aller-retour de batterie $\eta_{c,d}^{cycle}$ pour $C \times D$ différentes paires de taux *C* ou de taux *P* de charge et de décharge définis à l'étape A, dans lequel pour chaque cycle effectué, ledit rendement aller-retour par cycle $\eta_{c,d,j}^{cycle}$, pour *c, d* et *j* sélectionnés, est calculé :

- dans le cas du mode CC sélectionné, à partir de la charge extraite $C^{dis}_{c,d,j}$ et de la charge injectée $C^{ch}_{c,d,j}$ dans ladite batterie :

$$\eta^{cycle}_{c,d,j} = \frac{C^{dis}_{c,d,j}}{C^{ch}_{c,d,j}}$$

dans lequel lesdites charges $C^{ch}_{c,d,j}$ et $C^{dis}_{c,d,j}$ sont obtenues par intégration numérique du courant de charge dépendant du temps $I^{ch}_{c,d,j}(t)$ et du courant de décharge $I^{dis}_{c,d,j}(t)$ :

$$C^{ch}_{c,d,j} = \int I^{ch}_{c,d,j}(t) \cdot dt$$

$$C^{dis}_{c,d,j} = \int I^{dis}_{c,d,j}(t) \cdot dt$$

dans lequel lesdits courants $I^{ch}_{c,d,j}(t)$ et $I^{dis}_{c,d,j}(t)$ sont journalisés à chaque cycle, ou

- dans le cas du mode CP sélectionné, à partir de l'énergie extraite $E^{dis}_{c,d,j}$ et de l'énergie injectée $E^{ch}_{c,d,j}$ dans ladite batterie :

$$\eta^{cycle}_{c,d,j} = \frac{E^{dis}_{c,d,j}}{E^{ch}_{c,d,j}}$$

dans lequel lesdites énergies $E^{ch}_{c,d,j}$ et $E^{dis}_{c,d,j}$ sont obtenues par intégration numérique de la puissance de charge dépendant du temps $P^{ch}_{c,d,j}(t)$ et de la puissance de décharge $P^{dis}_{c,d,j}(t)$ :

$$E^{ch}_{c,d,j} = \int P^{ch}_{c,d,j}(t) \cdot dt$$

$$E^{dis}_{c,d,j} = \int P^{dis}_{c,d,j}(t) \cdot dt$$

dans lequel lesdites puissances $P^{ch}_{c,d,j}(t)$ et $P^{dis}_{c,d,j}(t)$ sont journalisées à chaque cycle, et

dans lequel les rendements aller-retour obtenus par cycle $\eta^{cycle}_{c,d,j}$ sont moyennés par le nombre de répétitions $J$ de l'étape A, ce qui amène les rendements aller-retour de batterie $\eta^{cycle}_{c,d}$ pour les valeurs $C$ et $D$ sélectionnées à se lire comme suit :

$$\eta^{cycle}_{c,d} = \frac{\sum_{j=1}^{J} \eta^{cycle}_{c,d,j}}{J}$$

C. la détermination de rendements unidirectionnels à partir des rendements aller-retour calculés de la batterie

$\eta_{c,d}^{cycle}$ à l'étape B, dans lequel $\eta_c^{ch}$ et $\eta_d^{dis}$ désignent respectivement des rendements de charge et de décharge unidirectionnels, en résolvant le problème d'optimisation non linéaire qui contient $C + D$ inconnues et $C \times D$ équations :

$$\text{Réduire au minimum} \sum_{c \in \Omega^C} \sum_{d \in \Omega^D} S_{c,d}^2$$

soumis aux contraintes suivantes :

$$\eta_c^{ch} \cdot \eta_d^{dis} = \eta_{c,d}^{cycle} + s_{c,d} \forall c \in \Omega^c, d \in \Omega^D$$

$$0 \leq \eta_c^{ch} \leq 1, \forall c \in \Omega^c$$

$$0 \leq \eta_d^{dis} \leq 1, \forall d \in \Omega^D$$

dans lequel $s_{c,d}$ est une variable de mou, et dans lequel la solution dudit problème d'optimisation susmentionné donne $\eta_c^{ch}$ et $\eta_d^{dis}$, dont la multiplication diverge le moins du rendement mesuré $\eta_{c,d}^{cycle}$ pour chaque paire de valeurs *{c, d}* sélectionnée.

2. Utilisation du procédé de modélisation de caractéristiques de rendements unidirectionnels de batterie selon la revendication 1 en mode CC pour la détermination du vecteur d'état de charge **SOC,** dans laquelle les étapes suivantes sont réalisées :

D. des rendements de charge $\eta_c^{ch}$ et de décharge $\eta_d^{dis}$ calculés à l'étape C pour une batterie donnée sont utilisés pour définir des caractéristiques de rendements linéaires par morceaux $\eta^C$ et $\eta^D$ pour la plage de taux *C* de charge/décharge opérationnels de batterie, dans laquelle lesdites caractéristiques de rendements sont définies comme suit :

$$\hat{\imath}^{ch} = \eta^C \left( i^{ch} \right) \text{ et } \hat{\imath}^{dis} = \eta^D \left( i^{dis} \right)$$

dans laquelle $\hat{\imath}^{ch}$ est le courant net injecté dans la batterie pendant la charge et il dépend du courant brut prélevé de la source externe $i^{ch}$, en même temps que le courant brut extrait de la batterie pendant la décharge $\hat{\imath}^{dis}$ dépend du courant net délivré au puits externe $i^{dis}$,
E. dans laquelle les fonctions $\eta^C$ et $\eta^D$ sont obtenues sous forme d'interpolations ou d'extrapolations effectuées pour des valeurs $i^{ch}$, $i^{dis}$ de courants réelles par rapport aux courants connus utilisés dans le cyclage de batterie à l'étape A, de préférence une interpolation linéaire, dans laquelle $H_c^{ch}$ représente une valeur de charge c sélectionnée de taux C de l'étape A et $G_c^{ch}$ sa valeur corrigée pour le rendement de charge unidirectionnel $\eta_c^{ch}$ obtenu à partir de l'étape C :

$$G_c^{ch} = \eta_c^{ch} \cdot H_c^{ch}, \forall c \in \Omega^c,$$

dans laquelle $H_d^{dis}$ représente une valeur de décharge d sélectionnée de taux *C* de l'étape A et $G_d^{dis}$ sa valeur corrigée pour le rendement de décharge $\eta_d^{dis}$ obtenu à l'étape C :

$$G_d^{dis} = \frac{H_d^{dis}}{\eta_d^{dis}}, \forall d \in \Omega^D$$

dans laquelle lesdites interpolations et lesdites extrapolations se lisent comme suit :

$$\eta^c\left(i^{ch}\right)$$

$$= \begin{cases} \dfrac{G_1^{ch}}{H_1^{ch}} \cdot i^{ch}, \text{si } i^{ch} \leq H_1^{ch} \\ G_c^{ch} + \dfrac{G_{c+1}^{ch} - G_c^{ch}}{H_{c+1}^{ch} - H_c^{ch}} \cdot \left(i^{ch} - H_c^{ch}\right), \text{si } H_c^{ch} < i^{ch} \leq H_{c+1}^{ch}, \text{pour } c = 1,2 \dots C - 1 \\ G_c^{ch} + \dfrac{G_c^{ch} - G_{c-1}^{ch}}{H_c^{ch} - H_{c-1}^{ch}} \cdot \left(i^{ch} - H_c^{ch}\right), \text{si } H_c^{ch} < i^{ch}, \text{pour } c = C \end{cases}$$

et

$$\eta^D(i^{dis}) = \begin{cases} \dfrac{G_1^{dis}}{H_1^{dis}} \cdot i^{dis}, \text{si } i^{dis} \leq H_1^{dis} \\ G_d^{dis} + \dfrac{G_{d+1}^{dis} - G_d^{dis}}{H_{d+1}^{dis} - H_d^{dis}} \cdot \left(i^{dis} - H_d^{dis}\right), \text{si } H_d^{dis} < i^{dis} \leq H_{d+1}^{dis}, \text{pour } d = 1 \dots D - 1 \\ G_d^{dis} + \dfrac{G_d^{dis} - G_{d-1}^{dis}}{H_d^{dis} - H_{d-1}^{dis}} \cdot \left(i^{dis} - H_d^{dis}\right), \text{si } H_d^{dis} < i^{dis}, \text{pour } d = D \end{cases}$$

F. dans laquelle les valeurs $\eta^C(i^{ch})$ et $\eta^D(i^{dis})$ obtenues ci-dessus, pour l'un quelconque des courants mesurés de charge brute et de décharge nette sélectionnés $i^{ch}, i^{dis}$, sont utilisées pour le calcul du vecteur d'état de charge $SOC$ pour la série temporelle $t$, $SOC = (soc_0, soc_1, \dots, soc_{t-1}, soc_t, \dots)$, dans laquelle chaque élément vectoriel $soc_t$ à un instant $t$ est calculé par rapport à la valeur $soc_{t-1}$ précédente connue pour l'intervalle de temps $\Delta t$ qui s'est produit juste avant l'instant $t$ à partir de la définition :

$$soc_t = soc_{t-1} + \Delta t \cdot \hat{\imath}_t^{ch} - \Delta t \cdot \hat{\imath}_t^{dis} \forall t \in \Omega^T$$

en utilisant les relations

$$\hat{\imath}_t^{ch} = \eta^c\left(i_t^{ch}\right) \text{ et } \hat{\imath}_t^{dis} = \eta^D\left(i_t^{dis}\right).$$

**3.** Utilisation du procédé de modélisation de caractéristiques de rendements unidirectionnels de batterie selon les revendications 1 et 2 en mode CC pour la détermination expérimentale de la capacité de charge de batterie $C^1$, dans laquelle les étapes suivantes sont réalisées :

G. la sélection d'un nombre $K$ de taux $C$ différents pour effectuer $K$ cycles complets de charge-décharge en mode courant constant-tension constante, à condition que :

(i) le taux $C$ sélectionné reste le même au cours du même cycle de charge et de décharge,
(ii) le cycle soit démarré avec soit une batterie complètement déchargée, soit complètement chargée, dans laquelle complètement déchargée signifie qu'une batterie est déchargée jusqu'à ce que le courant de décharge tombe au-dessous de la valeur de coupure basse définie, tout en maintenant la tension de la batterie à la limite de basse tension, et complètement chargée signifie qu'une batterie est chargée jusqu'à ce que le courant de charge tombe au-dessous de la valeur de coupure basse définie tout en maintenant la tension de la batterie à la limite de haute tension, et
(iii) chaque charge soit terminée lorsqu'une batterie est complètement chargée, en même temps que chaque décharge soit terminée lorsqu'une batterie est complètement déchargée, comme défini dans (ii), et

H. pour chaque cycle complet effectué à l'étape G, les courants journalisés $i_t^{ch}$ et $i_t^{dis}$ sont corrigés avec les résultats obtenus à l'étape E en utilisant des caractéristiques de rendements de charge $\eta^c$ et de décharge $\eta^D$, pour

obtenir les courants $\hat{\imath}_t^{ch}$ et $\hat{\imath}_t^{dis}$, qui sont intégrés dans le temps pour obtenir $K$ charges injectées $C_k^{batt,ch}$ et $K$ charges extraites $C_k^{batt,dis}$·, dans laquelle les charges obtenues sont moyennées pour calculer la capacité de charge de batterie :

$$C^I = \frac{\sum_{k=1}^{K} C_k^{batt,ch} + \sum_{k=1}^{K} C_k^{batt,dis}}{2 \cdot K}$$

**4.** Utilisation du procédé de modélisation de caractéristiques de rendements unidirectionnels de batterie selon la revendication 1 en mode CP pour la détermination du vecteur d'état d'énergie *SOE,* dans laquelle les étapes suivantes sont réalisées :

D. des rendements de charge $\eta_c^{ch}$ et de décharge $\eta_d^{dis}$ calculés à l'étape C pour une batterie donnée sont utilisés pour définir des caractéristiques de rendements linéaires par morceaux $\eta^C$ et $\eta^D$ pour la plage de taux $P$ de charge/décharge opérationnels de batterie, dans laquelle lesdites caractéristiques de rendements sont définies comme suit :

$$\hat{p}^{ch} = \eta^C\left(p^{ch}\right) \text{ et } \hat{p}^{dis} = \eta^D\left(p^{dis}\right)$$

dans laquelle $\hat{p}^{ch}$ est la puissance nette injectée dans la batterie pendant la charge et elle dépend de la puissance brute prélevée de la source externe $p^{ch}$, en même temps que la puissance brute extraite de la batterie pendant la décharge $\hat{p}^{dis}$ dépend de la puissance nette délivrée à un puits externe $p^{dis}$,
E. dans laquelle les fonctions $\eta^C$ et $n^D$ sont obtenues sous forme d'interpolations ou d'extrapolations effectuées pour des valeurs $p^{ch}$, $p^{dis}$ de puissances réelles par rapport aux puissances connues utilisées dans le cyclage de batterie à l'étape A, de préférence une interpolation linéaire, dans laquelle $H_c^{ch}$ représente une valeur de charge c sélectionnée de taux $P$ de l'étape A et $G_c^{ch}$ sa valeur corrigée pour le rendement de charge unidirectionnel $\eta_c^{ch}$ obtenu à partir de l'étape C :

$$G_c^{ch} = \eta_c^{ch} \cdot H_c^{ch}, \forall c \in \Omega^C,$$

dans laquelle $H_d^{dis}$ représente une valeur de décharge d sélectionnée de taux $P$ de l'étape A et $G_d^{dis}$ sa valeur corrigée pour le rendement de décharge $\eta_d^{dis}$ obtenu à l'étape C :

$$G_d^{dis} = \frac{H_d^{dis}}{\eta_d^{dis}}, \forall d \in \Omega^D$$

dans laquelle lesdites interpolations et lesdites extrapolations se lisent comme suit :

$$\eta^c(p^{ch}) = \begin{cases} \frac{G_1^{ch}}{H_1^{ch}} \cdot p^{ch}, \text{si } p^{ch} \leq H_1^{ch} \\ G_c^{ch} + \frac{G_{c+1}^{ch} - G_c^{ch}}{H_{c+1}^{ch} - H_c^{ch}} \cdot (p^{ch} - H_c^{ch}), \text{si } H_c^{ch} < p^{ch} \leq H_{c+1}^{ch}, \text{pour } c = 1,2 \dots C - 1 \\ G_c^{ch} + \frac{G_c^{ch} - G_{c-1}^{ch}}{H_c^{ch} - H_{c-1}^{ch}} \cdot (p^{ch} - H_c^{ch}), \text{si } H_c^{ch} < p^{ch}, \text{pour } c = C \end{cases}$$

et

$$\eta^D(p^{dis}) = \begin{cases} \dfrac{G_1^{dis}}{H_1^{dis}} \cdot p^{dis}, \text{si } p^{dis} \leq H_1^{dis} \\[2ex] G_d^{dis} + \dfrac{G_{d+1}^{dis} - G_d^{dis}}{H_{d+1}^{dis} - H_d^{dis}} \cdot \left(p^{dis} - H_d^{dis}\right), \text{si } H_d^{dis} < p^{dis} \leq H_{d+1}^{dis}, \text{pour } d = 1 \dots D - 1 \\[2ex] G_d^{dis} + \dfrac{G_d^{dis} - G_{d-1}^{dis}}{H_d^{dis} - H_{d-1}^{dis}} \cdot \left(p^{dis} - H_d^{dis}\right), \text{si } H_d^{dis} < p^{dis}, \text{pour } d = D \end{cases}$$

F. dans laquelle les valeurs $\eta^C(p^{ch})$ et $\eta^D(p^{dis})$ obtenues ci-dessus, pour l'une quelconque des puissances mesurées de charge brute et de décharge nette sélectionnées $p^{ch}$, $p^{dis}$, sont utilisées pour le calcul du vecteur d'état d'énergie SOE pour la série temporelle $t$, SOE = ($soe_0$, $soe_1$, ... , $soe_{t-1}$, $soe_t$, ... ), dans laquelle chaque élément vectoriel $soe_t$ à un instant $t$ est calculé par rapport à la valeur $soe_{t-1}$ précédente connue pour l'intervalle de temps $\Delta t$ qui s'est produit juste avant l'instant $t$ à partir de la définition :

$$soe_t = soe_{t-1} + \Delta t \cdot \hat{p}_t^{ch} - \Delta t \cdot \hat{p}_t^{dis} \forall t \in \Omega^T$$

en utilisant les relations

$$\hat{p}_t^{ch} = \eta^c\left(p_t^{ch}\right) \text{ et } \hat{p}_t^{dis} = \eta^D\left(p_t^{dis}\right).$$

5. Utilisation du procédé de modélisation de caractéristiques de rendements unidirectionnels de batterie selon les revendications 1 et 4 en mode CP, pour la détermination expérimentale de la capacité énergétique de batterie $C^E$, dans laquelle les étapes suivantes sont réalisées :

G. la sélection d'un nombre $K$ de taux $P$ différents pour effectuer $K$ cycles complets de charge-décharge en mode puissance constante-tension constante, à condition que :

(i) le taux $P$ sélectionné reste le même au cours du même cycle de charge et de décharge,
(ii) un cycle soit démarré avec soit une batterie complètement déchargée, soit complètement chargée, dans laquelle complètement déchargée signifie qu'une batterie est déchargée jusqu'à ce que le courant de décharge tombe au-dessous de la valeur de coupure basse définie, tout en maintenant la tension de la batterie à la limite de basse tension, et complètement chargée signifie qu'une batterie est chargée jusqu'à ce que le courant de charge tombe au-dessous de la valeur de coupure basse définie tout en maintenant la tension de la batterie à la limite de haute tension, et
(iii) chaque charge soit terminée lorsqu'une batterie est complètement chargée, en même temps que chaque décharge soit terminée lorsqu'une batterie est complètement déchargée, comme défini dans (ii), et

H. pour chaque cycle complet effectué à l'étape G, les puissances journalisées $p_t^{ch}$ et $p_t^{dis}$ sont corrigées avec les résultats obtenus à l'étape E en utilisant des caractéristiques de rendements de charge $\eta^c$ et de décharge $\eta^D$, pour obtenir les puissances $\hat{p}_t^{ch}$ et $\hat{p}_t^{dis}$, qui sont intégrées dans le temps pour obtenir $K$ énergies injectées $E_k^{batt,ch}$ et K énergies extraites $E_k^{batt,dis}$, dans laquelle les énergies obtenues sont moyennées pour calculer la capacité énergétique de batterie :

$$C^E = \frac{\sum_{k=1}^{K} E_k^{batt,ch} + \sum_{k=1}^{K} E_k^{batt,dis}}{2 \cdot K}$$

6. Utilisation du procédé de modélisation de caractéristiques de rendements unidirectionnels de batterie selon la revendication 4, dans laquelle le vecteur SOE pour la série temporelle $t$ est utilisé pour estimer une capacité de charge d'énergie une heure à l'avance pour le SOE instantané, lors d'une charge avec un taux $P$ donné.

7. Utilisation du procédé de modélisation de caractéristiques de rendements unidirectionnels de batterie selon la revendication 3, pour la détermination du paramètre d'intégrité SOH exprimé en pourcentage 0-100 %, dans laquelle le paramètre *SOH* dans le temps est défini comme $SOH_t = C_t^I / C_0^I$, et dans laquelle $C_0^I$ correspond à la première détermination de la capacité de charge moyenne de batterie $C^I$ effectuée lorsque la batterie est neuve, et $C_t^I$ est une valeur nouvellement déterminée $C^I$ pendant la période d'utilisation de batterie.

8. Utilisation du procédé de modélisation de caractéristiques de rendements unidirectionnels de batterie selon la revendication 5, pour la détermination du paramètre d'intégrité *SOH* exprimé en pourcentage 0-100 %, dans laquelle le paramètre *SOH* dans le temps est défini comme $SOH_t = C_t^E / C_0^E$, et dans laquelle $C_0^E$ correspond à la première détermination de la capacité énergétique moyenne de batterie $C^E$ effectuée lorsque la batterie est neuve, et $C_t^E$ est une valeur nouvellement déterminée $C^E$ pendant la période d'utilisation de batterie.

9. Utilisation du procédé de modélisation de caractéristiques de rendements unidirectionnels de batterie selon l'une quelconque des revendications 2-8, dans laquelle le procédé est exécuté pour différentes températures ambiantes $T^E$.

**Charging one-way efficiencies**

Figure 1A

**Discharging one-way efficiencies**

Figure 1B

Figure 2A

Figure 2B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011000872 A1, Mamadou, K.
- EP 2449392 B1
- US 9075117 B
- WO 2013175005 A1, Fernandez E.
- EP 2856187 B1
- WO 2018084939 A1, J.A. CRAWFORD
- CN 111273177 A
- CN 113125967 A

**Non-patent literature cited in the description**

- **MAMADOU, K.** ; **LEMAIRE, E.** ; **DELAILLE, A.** ; **RIU, D.** ; **HING, S. E.** ; **BULTEL, Y.** Definition of a State-of-Energy Indicator (SoE) for Electrochemical Storage Devices: Application for Energetic Availability Forecasting.. *Journal of the Electrochemical Society*, 2012, vol. 159 (8), A1298-A1307
- **E. REDONDO-IGLESIAS** ; **P. VENET** ; **S. PELISSIER**. Efficiency Degradation Model of Lithium-Ion Batteries for Electric Vehicles. *IEEE Transactions on Industry Applications*, March 2019, vol. 55 (2), 1932-1940
- **GATTA, F. M.** ; **GERI, A.** ; **LAURIA, S.** ; **MACCIONI, M.** ; **PALONE, F.** Battery energy storage efficiency calculation including auxiliary losses: Technology comparison and operating strategies. *2015 IEEE Eindhoven PowerTech*, 2015